(19) Europäisches Patentamt / European Patent Office / Office européen des brevets

(11) **EP 3 155 609 B1**

(12) **FASCICULE DE BREVET EUROPEEN**

(45) Date de publication et mention
de la délivrance du brevet:
**24.07.2019 Bulletin 2019/30**

(21) Numéro de dépôt: **15732560.6**

(22) Date de dépôt: **12.06.2015**

(51) Int Cl.:
*G10H 1/44* (2006.01)      *G10H 1/00* (2006.01)
*H03D 3/02* (2006.01)

(86) Numéro de dépôt international:
**PCT/EP2015/063240**

(87) Numéro de publication internationale:
**WO 2015/189419 (17.12.2015 Gazette 2015/50)**

(54) **ANALYSE FREQUENTIELLE PAR DÉMODULATION DE PHASE D'UN SIGNAL ACOUSTIQUE**

FREQUENZANALYSE MITTELS PHASENDEMODULATION VON EINEM AKUSTISCHEN SIGNAL

FREQUENCY ANALYSIS BY PHASE DEMODULATION OF AN ACOUSTIC SIGNAL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.06.2014 FR 1455456**

(43) Date de publication de la demande:
**19.04.2017 Bulletin 2017/16**

(73) Titulaire: **Centre National de la Recherche
Scientifique
(CNRS)
75016 Paris (FR)**

(72) Inventeur: **HELIE, Thomas
75013 Paris (FR)**

(74) Mandataire: **Lavoix
2, place d'Estienne d'Orves
75441 Paris Cedex 09 (FR)**

(56) Documents cités:
**FR-A- 1 427 657      FR-E- 56 159**

- **DESAINTE-CHATHERINE M ET AL:
"HIGH-PRECISION FOURIER ANALYSIS OF
SOUNDS USING SIGNAL DERIVATIVES",
JOURNAL OF THE AUDIO ENGINEERING
SOCIETY, vol. 48, no. 7/08, 2 juillet 2000
(2000-07-02), pages 654-667, XP001001994, NEW
YORK, NY, US ISSN: 1549-4950**
- **CORNU C ET AL: "Generalized Representation of
Phase Derivatives for Regular Signals", IEEE
TRANSACTIONS ON SIGNAL PROCESSING,
IEEE SERVICE CENTER, NEW YORK, NY, US, vol.
55, no. 10, 2 octobre 2007 (2007-10-02), pages
4831-4838, XP011192563, ISSN: 1053-587X, DOI:
10.1109/TSP.2007.896280**
- **MARCHAND SYLVAIN: "Fourier-based methods
for the spectral analysis of musical sounds",
21ST EUROPEAN SIGNAL PROCESSING
CONFERENCE (EUSIPCO 2013), EURASIP, 9
septembre 2013 (2013-09-09), pages 1-5,
XP032593686,**
- **LONG JIANJUN ET AL: "Estimating Phase
Difference and Lead of Discrete Cosine
Ultrasonic Wave Signals Based on Hilbert
Transform and Lissajous Figure Features",
MEASURING TECHNOLOGY AND
MECHATRONICS AUTOMATION (ICMTMA), 2010
INTERNATIONAL CONFERENCE ON, IEEE,
PISCATAWAY, NJ, USA, 13 mars 2010
(2010-03-13), pages 145-148, XP031673240, ISBN:
978-1-4244-5001-5**
- **Bertrand David: "Analyse et représentation de
signaux acoustiques modulés Application à la
mesure du vibrato musical", , 2 septembre 2015
(2015-09-02), pages 1-13, XP055210725, Paris
Extrait de l'Internet:
URL:http://web.archive.org/web/20150902074
748/http://gsam.sfa.free.fr/manifestations
/vibrato/signal.pdf [extrait le 2015-09-02]**

**Description**

## DOMAINE TECHNIQUE

Il est question du domaine technique du traitement des signaux acoustiques. Il est en particulier question d'un procédé et d'un système 400 permettant un tel traitement.

## ETAT DE LA TECHNIQUE

Les signaux acoustiques, en particulier les signaux sonores font l'objet d'enregistrements afin d'être analysés.

Afin de tirer des informations de ces enregistrements, il est connu d'appliquer une transformée de Fourier convertissant le signal du domaine temporel au domaine spectral.

De nombreux types de transformées ont été élaborés afin de rendre plus accessibles certaines informations recherchées.

Cependant, les techniques d'analyse fréquentielles connues offrent une résolution limitée, notamment en raison du principe d'incertitude temps-fréquence.

Ceci limite d'autant les analyses possibles des enregistrements, et donc les applications envisageables.

Par exemple, dans le domaine de l'analyse sonore, il est difficile d'estimer précisément des fréquences de partiels, par exemple des hauteurs de notes à partir de sons réels. De plus, la hauteur d'une note est un critère qui devient difficilement définissable dès que le signal correspondant n'est pas parfaitement périodique, par exemple en cas d'inharmonicité. Il en résulte qu'il est difficile de fournir des informations précises, en particulier de représenter de telles informations.

"Fourier-based methods for the spectral analysis of musical sounds", MARCHAND Sylvain, 21st European Signal Processing Conférence (EUSIPCO 2013), 2013-09-09, EURASIP définit trois méthodes (phase vocoder, ré-assignement spectral ou méthode par dérivées) pour estimer la modulation d'amplitude et la fréquence pour chaque partiel d'une décomposition de Fourier d'un son musical.

FR 56 159 définit l'analyse par une seconde porteuse très proche d'une porteuse modulée produisant une différence de phase et résultant en une figure elliptique dite de Lissajous sur un oscilloscope. Une stroboscopie de l'écran à la fréquence de modulation permet d'observer la variation de la phase.

## PRESENTATION GENERALE

Un but de l'invention est de pallier au moins un des inconvénients présentés ci-avant.

Un but de l'invention est de permettre une analyse fréquentielle plus fine.

A cet effet, il est prévu un procédé de traitement de données acoustiques, comprenant des étapes de:

- réception de données acoustiques correspondant à un signal acoustique transformé dans le domaine fréquentiel à partir d'un signal acoustique dans le domaine temporel enregistré par au moins un capteur acoustique,
- pour au moins une fréquence du domaine fréquentiel, démodulation de la phase du signal acoustique transformé, et
- calcul d'un indice de constance de la phase démodulée.

L'invention est avantageusement complétée par les caractéristiques suivantes, prises seules ou en une quelconque de leurs combinaisons techniquement possibles :

- la phase démodulée est obtenue par une formule du type :

$$\Phi_{demod}(f,t) = \Phi_{spectr}(f,t) - 2\pi ft$$

où $\Phi_{demod}$ représente la phase démodulée pour la fréquence $f$ et au temps $t$, et où $\Phi_{spectr}$ représente la phase du signal transformé pour la pour la fréquence $f$ et au temps $t$ ;
- le calcul d'un indice de constance de la phase démodulée comprend l'application d'un filtre passe-bas, le filtre passe-bas étant adapté pour réaliser une atténuation en fonction de la vitesse de rotation de la phase démodulée ;
- le calcul d'un indice de constance de la phase démodulée comprend, préalablement à l'application du filtre passe-bas la conversion de la phase démodulée en une exponentielle complexe de module constant, le filtre passe-bas étant appliqué à l'exponentielle complexe, l'indice de constance de la phase démodulée résultant du module d'une sortie complexe du filtre passe-bas ;
- le calcul d'un indice de constance de la phase démodulée comprend le calcul d'une différence de phase démodulée entre deux temps pour la fréquence du domaine fréquentiel ;

- l'indice de constance de phase démodulée τ est est paramétré par une précision fréquentielle réglable ;
- des étapes de :

  ◦ réception d'une valeur de variation de fréquence à détecter ;
  ◦ réception de données acoustiques correspondant au signal acoustique dans le domaine temporel enregistré par l'au moins un capteur acoustique ;
  ◦ transformation du signal acoustique dans le domaine temporel en le signal dans le domaine fréquentiel par transformée de Fourier discrète pondérée par une fenêtre d'analyse ;

  la transformée étant réalisée avec un pas d'avancement déterminé de sorte que l'inverse du double du pas d'avancement est supérieur à :

  ◦ la largeur du lobe principal de la fenêtre d'analyse dans le domaine de Fourier, et à
  ◦ la valeur de variation à détecter ;

- le signal acoustique enregistré est un signal sonore et dans lequel le signal acoustique dans le domaine temporel enregistré est échantillonné ;
- une étape de construction d'une image adaptée pour être affichée sur un terminal, l'image étant construite à partir des données acoustiques et de l'indice de constance de phase démodulée.
- la construction de l'image comprend un élément visuel correspondant à la fréquence du domaine fréquentiel, la représentation de l'élément visuel étant fonction de l'amplitude de la fréquence et de l'indice de constance de phase démodulée.

L'invention concerne également un système de traitement de données acoustiques, adapté pour mettre en oeuvre un tel procédé, comprenant :

- un module de réception de données acoustiques correspondant à un signal acoustique transformé dans le domaine fréquentiel à partir d'un signal acoustique dans le domaine temporel enregistré par au moins un capteur acoustique ;
- un module de démodulation de la phase du signal acoustique transformé pour au moins une fréquence du domaine fréquentiel ; et
- un module de calcul d'un indice de constance de la phase démodulée.

## FIGURES

D'autres objectifs, caractéristiques et avantages apparaitront à la lecture de la description qui suit donnée à titre illustratif et non limitatif en référence aux figures, parmi lesquels :

- la figure 1 représente un procédé selon un exemple de mode de réalisation de l'invention,
- la figure 2 représente une étape de réalisation d'une image selon un autre exemple de mode de réalisation de l'invention,
- la figure 3 représente une représentation visuelle réalisée par l'étape de la figure 2,
- la figure 4 représente un système selon un autre exemple de mode de réalisation de l'invention,
- les figures 5a et 5b représentent un traitement des harmoniques selon un autre exemple de mode de réalisation de l'invention, et
- la figure 6 représente une représentation visuelle comprenant un élément visuel supplémentaire,.

## DESCRIPTION DETAILLEE

### Procédé

#### *Réception de données acoustiques*

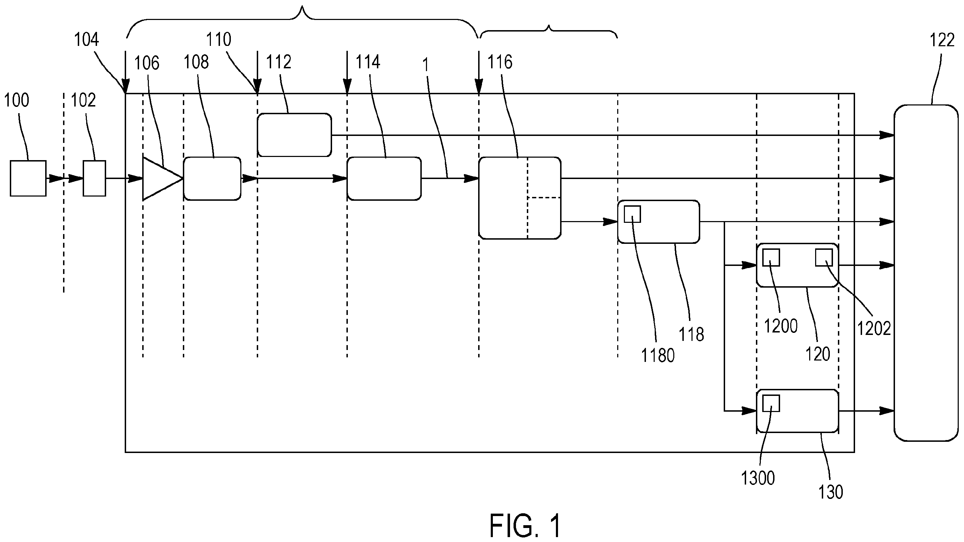

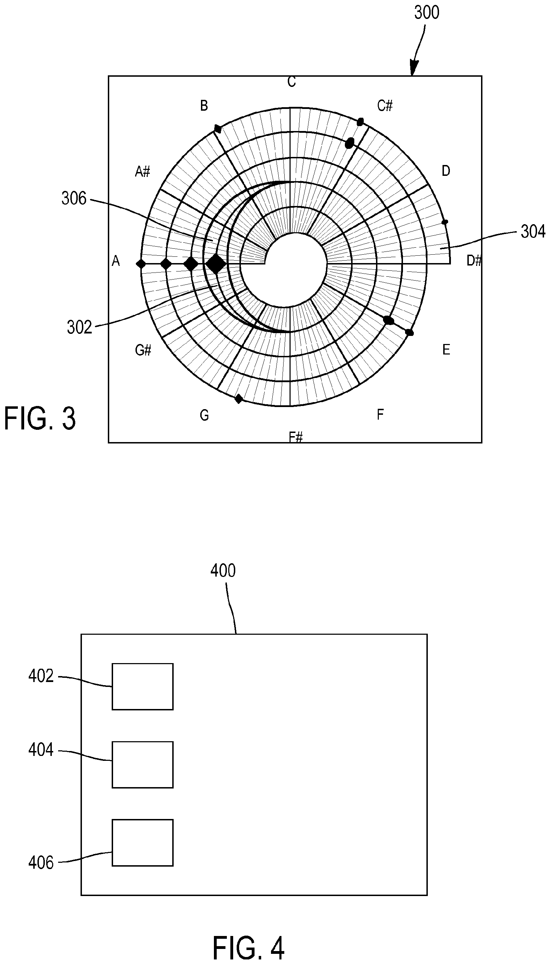

En référence à la figure 1, il est décrit un procédé de traitement de données acoustiques.
Le procédé est par exemple mis en oeuvre par un système 400 de traitement de données acoustiques, par exemple un système 400 tel que représenté figure 4 et tel que décrit plus en détail plus loin.
Le procédé comprend une étape 110 de réception de données acoustiques transformées. Les données acoustiques correspondent à un signal acoustique transformé dans le domaine fréquentiel à partir d'un signal acoustique dans le domaine temporel. Le signal acoustique dans le domaine temporel est par exemple un signal acoustique enregistré dans le domaine temporel par au moins un capteur acoustique.

Le signal acoustique enregistré peut être un signal infrasonore, sonore ou ultrasonore. Le signal acoustique enregistré est ainsi par exemple un signal sonore. Le signal acoustique enregistré peut être un signal monophonique.

Le signal acoustique dans le domaine temporel enregistré peut être échantillonné. L'échantillonnage peut être réalisé à une fréquence déterminée, par exemple 44100 Hz.

Le signal acoustique dans le domaine temporel comprend par exemple une pluralité de trames, par exemple de trames successives ayant chacune une durée déterminée, par exemple une même durée de l'ordre de 50 ms, par exemple avec un pas d'avancement déterminé, par exemple de l'ordre de 5 ms.

*Etapes préalables à la réception*

*Réception de données acoustiques correspondant au signal acoustique dans le domaine temporel*

Les données reçues à l'étape 110 peuvent être des données stockées au préalable (non représenté).

Alternativement, comme illustré figure 1, le procédé peut comprendre une étape 104 de réception de données acoustiques correspondant au signal acoustique dans le domaine temporel enregistré par l'au moins un capteur acoustique.

Le procédé peut alors comprendre une étape 106 d'application d'un gain au signal acoustique dans le domaine temporel. Le gain est par exemple un gain multiplicatif. Le gain peut être appliqué de sorte à constituer un réglage de niveau pour le confort d'un utilisateur utilisant ces données ou destiné à utiliser ces données.

Le procédé peut comprendre une étape 108 de transformation du signal acoustique dans le domaine temporel pour obtenir le signal dans le domaine fréquentiel. L'étape 108 de transformation peut être réalisée suite à l'étape 106 d'application de gain ou en l'absence d'étape d'application de gain.

Une telle transformation 108 est par exemple réalisée par transformée de Fourier, par exemple par transformée de Fourier discrète. La transformée de Fourier discrète est par exemple appliquée à chaque trame de signal acoustique.

La transformée de Fourier est par exemple une transformée de Fourier rapide.

La transformée de Fourier peut être pondérée par une fenêtre d'analyse. La fenêtre d'analyse est par exemple une fenêtre de Hanning.

La fenêtre d'analyse peut être une fenêtre dépourvue de lobe secondaire, par exemple sur un nombre de points étant une puissance de deux, par exemple 4096, par exemple une fenêtre telle que décrite dans T. Hélie « Amélioration de l'extraction de partiels dans les signaux sonores », Rapport de Stage Ingénieur, 1996. Une telle fenêtre permet de ne plus perturber l'interprétation visuelle des lobes puisque ceux-ci ne peuvent plus correspondre à des lobes secondaires.

La transformée de Fourier peut être réalisée avec un pas d'avancement $p$ déterminé. Le pas d'avancement est par exemple déterminé de sorte à vérifier une condition du type :

$$l \le \frac{1}{2p}$$

c'est-à-dire que l'inverse du double du pas d'avancement $p$ est supérieur à la largeur $l$ du lobe principal de la fenêtre d'analyse dans le domaine de Fourier. Le pas d'avancement est par exemple de l'ordre de 5 ms.

Le procédé peut comprendre une étape de réception d'une variation de fréquence (vibrato, glissando, etc.), par exemple un signal incluant une telle variation, de valeur de variation de fréquence v à détecter.

Le pas d'avancement peut alors en complément, être déterminé de sorte à vérifier une condition du type :

$$v \le \frac{1}{2p}$$

c'est-à-dire que l'inverse du double du pas d'avancement $p$ est supérieur à la valeur de variation $v$ à détecter.

Il est ainsi possible de s'assurer que les variations attendues seront effectivement détectées et correctement traitées. De même, une telle condition permet d'améliorer la précision du procédé en excluant les variations trop importantes.

En particulier, dans le cas de données acoustiques utilisées en vue de mettre en oeuvre un accordeur, il n'est pas nécessaire de détecter des variations de type vibrato.

Une telle analyse temps/fréquence, en particulier une telle transformation, peut être réalisée conformément à L. Cohen « Time-Frequency Analysis », Prentice-Hall, New York, 1995.

*Enregistrement d'un signal acoustique dans le domaine temporel*

Les données acoustiques correspondant au signal acoustique dans le domaine temporel enregistré par l'au moins un capteur acoustique reçues à l'étape 104 peuvent être des données stockées au préalable (non représenté).

Alternativement, comme illustré figure 1, le procédé peut comprendre une étape 100 d'enregistrement d'un signal acoustique dans le domaine temporel par l'au moins un capteur acoustique. Il peut s'agir par exemple d'un enregistrement à la volée.

Le procédé peut également comprendre une étape 102 d'échantillonnage du signal acoustique enregistré. L'échantillonnage peut être réalisé à une fréquence déterminée, par exemple 44100 Hz.

*Démodulation de phase*

Le procédé comprend une étape 118 de démodulation de la phase du signal acoustique transformé.

La démodulation 118 est réalisée pour une ou plusieurs fréquences du domaine fréquentiel, typiquement pour une ou plusieurs fréquence(s) d'analyse prédéterminée(s).

L'étape 118 de démodulation peut comprendre une étape 1180 d'encodage de la phase, par exemple d'encodage par une valeur, par exemple d'encodage par une valeur rationnelle, par exemple par un entier, par exemple un entier positif.

La phase du signal acoustique transformé est par exemple encodée avec un nombre de bits $k_{bits}$, par exemple 32.

La formule de passage entre la valeur en radians $\Phi_{rad}$ de la phase, comprise par exemple entre 0 et $2\pi$, et l'entier encodant la phase $\Phi_{int}$ est par exemple du type :

$$\Phi_{int} = \text{Floor}\big(\Phi_{rad} \times 2^{k_{bits}}/2\pi\big)$$

où *Floor(.)* est à la partie entière arrondie par défaut. Il est ainsi possible de conserver la classe d'équivalence « modulo $2\pi$ » par cet encodage.

La phase démodulée peut être obtenue par une formule du type :

$$\Phi_{demod}(f,t) = \Phi_{spectr}(f,t) - 2\pi ft \quad mod\ 2\pi$$

où $\Phi_{demod}$ représente la phase démodulée pour la fréquence *f* et au temps *t,* et où $\Phi_{spectr}$ représente la phase du signal transformé pour la fréquence *f* et au temps *t,* par exemple le temps t associé à une trame en cours, par exemple le temps de début de trame, le temps *t* avançant par exemple au temps d'avancement.

$\Phi_{spectr}$ est en radians dans la formule. Alternativement, comme indiqué ci-dessus, la phase démodulée peut être au préalable encodée, par exemple selon l'étape d'encodage décrite ci-dessus sous la forme de l'entier $\Phi_{int}$ dont l'encodage assure le modulo, et dans quel cas la formule de démodulation doit être adaptée en conséquence.

La fréquence f est par exemple une fréquence d'analyse donnée. Le temps t est par exemple un temps de trame, par exemple de début de trame.

La phase démodulée peut être obtenue par une telle formule appliquée de manière discrète à un temps $t_n$ obtenu par incrémentation d'un pas d'avancement. Le temps $t_n$ pour la n^ème incrémentation est par exemple obtenu par une formule du type :

$$t_n = \text{n} \times t_{av}$$

où $t_{av}$ est le pas d'avancement, et est par exemple constant à chaque incrémentation.

L'étape de démodulation peut ainsi comprendre une étape d'application d'une formule de démodulation pour cet encodage, du type :

$$\Phi_{demod}(f,t_n) = \Phi_{spectr}(f,t_n) + \Delta_{demod}$$

où le vecteur $\Delta_{demod}$ est rafraichi à chaque temps t_n par un formule du type :

$$\Delta_{demod} = \Delta_{demod} + \delta$$

où $\delta$ est l'encodage entier positif de $-2\pi f t_{av}$ ou vaut $-2\pi f t_{av}$ si le calcul est réalisé en radians, pour chaque fréquence analysée $f$, le pas d'avancement $t_{av}$ étant par exemple fourni par un paramètre stocké éventuellement converti en une unité de temps utilisée, par exemple en secondes. Ainsi $\Delta_{demod}$ est un paramètre dépendant de f et de $t_n$. Le terme $-2\pi f t_{av}$ peut n'être calculé qu'une seule fois, par exemple à chaque nouveau réglage d'une fréquence de référence par l'utilisateur.

Les quantités $\Phi_{demod}$, $\Phi_{spectr}$ $\Delta_{demod}$ et $\delta$ peuvent exprimées en radians modulo une certaine valeur, par exemple $2\pi$. Ces quantités avec le modulo peuvent être encodées par un entier de comme expliqué ci-dessus.

De plus, lorsque l'encodage des phases est réalisé sur au moins 32 bits, l'erreur cumulée dans $\Phi_{demod}$ via sa formule de mise à jour n'entraîne une déviation de $2\pi$ qu'après une durée supérieure à $2^{k_{bits}+1}p$, soit au moins 11930 heures pour un pas d'avancement $p$ $de$ 5ms et un $k_{bits}$ de 32 bits. Une telle démodulation a donc une précision qui dépasse très largement l'ordre de grandeur requis qui est par exemple de l'ordre de la minute.

## Calcul d'un indice de constance de la phase démodulée

Le procédé comprend une étape 120 et/ou 130 de calcul d'un indice de constance de la phase démodulée, par exemple d'au moins un indice de constance de la phase démodulée, par exemple d'une pluralité d'indices de constance de la phase démodulée, par exemple d'un indice de constance de la phase démodulée pour une fréquence d'analyse prédéterminée. L'indice de constance de la phase démodulée peut ainsi être fourni en sortie d'une telle étape 120 et/ou 130.

Par indice de constance de la phase démodulée, on entend par exemple un premier indice de constance de la phase démodulée tel que décrit plus bas, ou un deuxième indice de constance de la phase démodulée tel que décrit plus loin, ou un indice de constance de la phase démodulée basé sur les premier et deuxième indices de constance de la phase démodulée.

Un tel indice permet d'évaluer, pour un partiel, avec une résolution réglable, la cohérence entre une fréquence d'analyse et la fréquence du partiel.

Un tel indice de constance de phase démodulée permet d'obtenir une précision fréquentielle sur les composantes du signal analysé bien meilleure que celle fournie par la transformée de Fourier.

## Premier exemple d'indice de constance de la phase démodulée

Le procédé peut comprendre une étape 120 de calcul d'un premier indice de constance de la phase démodulée.

Le calcul 120 de l'indice de constance de la phase démodulée peut comprendre l'application 1202 d'un filtre passe-bas.

Le filtre passe-bas est par exemple adapté pour réaliser une atténuation en fonction de la vitesse de variation de la phase démodulée, par exemple la vitesse de rotation de la phase démodulée.

Le calcul 120 de l'indice de constance de la phase démodulée peut comprendre, préalablement à l'application 1202 du filtre passe-bas, la conversion 1200 de la phase démodulée en une exponentielle complexe de module constant.

Le procédé permet ainsi de construire un réhausseur de stationnarité fréquentielle des composantes spectrales de données acoustiques, en particulier d'un son. En effet, le calcul d'un indice de constance de phase démodulée permet de mettre en évidence de manière efficace qu'une composante spectrale correspond parfaitement à une fréquence d'analyse.

La déviation dans le temps de la phase démodulée est par exemple proportionnelle à la déviation de fréquence entre la fréquence de la composante analysée et la fréquence de démodulation.

En effet, pour une composante $x_1(t) = A_1 e^{2i\pi f_1 t + \varphi_1}$, d'amplitude $A_1$, de fréquence fixe $f_1$, et de phase $\varphi_1$ à l'instant $t = 0$ présente dans le signal complet, la phase instantanée $\Phi_1(t) = 2i\pi f_1 t + \varphi_1$ démodulée à une fréquence d'analyse f est $\Phi_{1demod}(t,f) = \mathrm{Arg}(x_1(t) \times e^{-2i\pi f t}) = 2\pi t (f_1 - f) + \varphi_1$. Un tel résultat met en évidence que $\Phi_{1demod}$ est cyclique, par exemple modulo $2\pi$, de fréquence $f_1 - f$, c'est-à-dire la déviation de fréquence entre la composante analysé $f_1$ et la fréquence de démodulation $f$.

Le filtre passe-bas est par exemple appliqué à l'exponentielle complexe, par exemple aux parties réelles et imaginaires séparément. Le signal complexe ainsi construit reste constant si la phase démodulée est constante et tourne sur le cercle unité si la phase démodulée évolue.

La conversion 1200 de la phase démodulée en une exponentielle complexe peut être réalisée via une table de conversion. La table de conversion est par exemple une table de valeurs pré-calculées avec une résolution d'encodage des phases déterminée, par exemple de l'ordre de 10 bits.

A cet effet, des bits de poids fort, par exemple 10 bits, sont prélevés de l'entier, par exemple encodé sur 32

bits. Pour les $2^{10}$ valeurs N possibles entre 0 et $2^{10}$-1, on a par exemple pré-calculé et stocké dans une telle table de valeurs pré-calculées des valeurs complexes $e^{2i\pi N}/2^{10}$ encodées par exemple par deux flottants ou deux doubles. Il est ainsi possible d'éviter le calcul de l'exponentielle complexe et de limiter à $2^{10}$ le nombre de paires de nombres, par exemple de flottants, à stocker en mémoire.

Le filtre passe-bas est par exemple un filtre de type Butterworth, par exemple tel que décrit dans : A. V. Oppenheim, R. W. Schafer, « Digital Signal Processing », 3rd edition, 2011. Prentice-Hall. Un tel filtre est par exemple de gain le plus plat possible en dessous de la fréquence de coupure, par exemple un gain proche de 1. La fréquence de coupure est par exemple de l'ordre de 6 Hz. La fréquence de coupure peut ainsi permettre de régler la qualité de constance de phase souhaitée.

Le filtre passe-bas peut être appliqué de sorte que l'indice de constance de la phase démodulée résulte du module d'une valeur complexe formant une sortie complexe fournie en sortie du filtre passe-bas. L'indice de constance de la phase démodulée peut ainsi par exemple être le module de la sortie du filtre.

La valeur de l'indice peut par exemple être de l'ordre du module de l'entrée (valeur 1) si le signal d'entrée tourne à une fréquence inférieure à la fréquence de coupure, et être atténuée au-delà, d'autant plus que l'argument du signal complexe d'entrée tourne vite et que l'ordre du filtre est élevé.

La sortie du filtre passe-bas peut être saturée si son module dépasse une valeur déterminée, par exemple le module d'entrée.

La phase étant définie modulo $2\pi$, une plus grande déviation de fréquence détectable sans repliement spectral par le calcul de la déviation de phase démodulée est par exemple de l'ordre de la moitié de l'inverse du pas d'avancement $p$, par exemple une déviation de l'ordre de 100Hz pour un pas d'avancement de 5 ms.

La plus grande déviation détectable est par exemple déterminée de sorte à être supérieure aux variations musicales que l'utilisateur souhaite considérer. Ces variations sont par exemple les vibratos et/ou les battements. Alternativement ou en complément, la plus grande déviation détectable est par exemple déterminée de sorte à être inférieure aux variations musicales que l'utilisateur souhaite rejeter, par exemple celles propres à un environnement bruyant.

La plus grande déviation détectable est par exemple déterminée de sorte à être supérieure à la largeur du lobe principal de la fenêtre d'analyse dans le domaine de Fourier.

Ainsi, le pas d'avancement peut être déterminé de sorte à vérifier une condition du type :

$$l \leq \frac{1}{2p}$$

c'est-à-dire que l'inverse du double du pas d'avancement $p$ est supérieur à la largeur $l$ du lobe principal de la fenêtre d'analyse dans le domaine de Fourier. La phase démodulée peut ainsi être échantillonnée à la période p. Par conséquent, dans le lobe principal, l'évaluation de la constance de la phase démodulée dans le temps peut alors être significative. Ceci permet d'améliorer l'évaluation de la constance par rapport à une constance apparente qui peut être due à un repliement spectral, ce phénomène étant ainsi rejeté hors du lobe principal et donc peu perturbatif.

L'indice de constance de phase démodulée permet ainsi de discriminer si une puissance associée à une fréquence obtenue par analyse temps/fréquence est attribuée à une composante sinusoïdale stationnaire située dans la plage tolérée, par exemple tolérée par la fréquence de coupure, ou si elle est en dehors.

L'exploitation de l'indice de constance de la phase démodulée permet d'affiner très significativement la finesse d'analyse fréquentielle et la pertinence d'une restitution visuelle d'une telle analyse et de rejeter des composantes perturbatives à fréquence non-stable ou non-stationnaire, par exemple de type voix parlée, bruit, impulsions.

Ainsi en choisissant une fréquence de coupure très fine, par exemple inférieure à 2 Hz, par exemple inférieure à 1 Hz, il est possible de rejeter la plupart des bruits ambiants, ce qui a un intérêt pour une utilisation d'accordeur.

Particulièrement, dans une utilisation du procédé en vue de réaliser un accordage, il est possible d'obtenir une grande précision. Il est ainsi possible de choisir une fréquence de coupure faible, par exemple de l'ordre de 2Hz ou même de 1Hz (accordeur fin).

Dans une utilisation du procédé en vue d'analyser une musique enregistrée, il est possible de moduler la précision de sorte à pouvoir identifier un vibrato. La fréquence de coupure peut alors être de l'ordre de 6Hz à 8Hz.

Un problème typique de l'analyse spectrale résulte du principe d'incertitude temps/fréquence, selon lequel il n'est pas possible de régler indépendamment les résolutions temporelles et fréquentielles.

Le procédé décrit permet de rétablir artificiellement une telle forme d'indépendance, de sorte à affiner la précision fréquentielle en introduisant une régularisation d'intérêt. En effet, dans le lobe principal associé à une composante sinusoïdale, la phase démodulée n'est constante dans le temps qu'à une unique fréquence : le calcul de la constance de cette phase permet d'affiner sensiblement, dynamiquement, la localisation fréquentielle d'une telle composante sans agrandir la durée de la fenêtre d'analyse, et donc tout en conservant une précision temporelle fine, utile continuer de détecter des composantes non sinusoïdales résultant par exemple d'impacts, de bruits, et/ou de variations rapides.

Pour une durée de fenêtre d'analyse fixée, c'est-à-dire pour une résolution temporelle fixée, le procédé permet de repérer dans le spectre les composantes dont la vitesse de déroulement de phase au cours du temps est cohérente avec la fréquence analysée, dans une plage déterminée qui, précisément, fixe la résolution fréquentielle finale souhaitée dépendant de la fréquence de coupure du filtre passe-bas.

Par exemple, en permettant de construire un indice descripteur de constance de phase proche de 1 lorsque les phases démodulées ont des cycles, par exemple de type modulo $2\pi$, par exemple de fréquence $f1$-$f$, inférieure à la résolution fréquentielle finale souhaitée, et s'approchant rapidement de 0 lorsque la fréquence est supérieure à la résolution fréquentielle finale souhaitée , il est possible de caractériser la plage prédéterminée et d'atteindre la résolution fréquentielle cible .

En particulier, pour chaque fréquence $f$ calculée et à analyser, le procédé permet de construire la phase démodulée du spectre estimé à la fréquence $f$ pour chaque temps de trame $t_n$. La fréquence f appartenant par exemple à une grille des fréquences, par exemple une grille de fréquences accordées sur un diapason.

Lorsque la composante spectrale pour $f$ est parfaitement stable et accordée sur la fréquence $f$, la vitesse de rotation de la phase démodulée correspondante calculée est nulle.

Lorsque la composante spectrale de fréquence stable est accordée sur $f+\delta f$, c'est-à-dire qu'elle est à peine décalée, avec par exemple $\delta f$ de l'ordre de 1 Hz, l'amplitude spectrale correspondante obtenue par transformée de Fourier reste significativement grande et peu modifiée, notamment à cause de la taille du lobe principal et du principe d'incertitude. Cependant, la vitesse de rotation de la phase démodulée, a une valeur fonction du décalage, par exemple fonction linéaire du décalage, par exemple égale au décalage.

Le procédé permet ainsi de construire un indice caractéristique de la résolution fréquentielle souhaitée.

Selon un exemple, un signal complexe de module 1 avec une phase démodulée tournant sur le cercle unité à la fréquence $\delta f$ peut être filtré par un filtre passe-bas. Si la fréquence de coupure est plus haute que $\delta f$, le signal de sortie est par exemple similaire à celui de l'entrée. Dans le cas contraire, le signal de sortie a par exemple un module significativement atténué. Le module, forme par exemple l'indice de constance de phase démodulée, et forme ainsi un indicateur permettant de déterminer si une composante spectrale est ou non dans une plage de résolution fréquentielle déterminée.

Il est ainsi possible d'obtenir une résolution fréquentielle affinée qui permet de dépasser le problème d'incertitude temps/fréquence.

L'indice de constance de phase permet d'être plus sélectif que la largeur du lobe principal de la fenêtre d'analyse de Fourier tout en indiquant quelles sont les composantes spectrales pour lesquelles la phase démodulée est cohérente avec la fréquence d'analyse.

*Deuxième exemple d'indice de constance de la phase démodulée*

En complément ou alternativement au calcul d'un premier indice de constance de la phase démodulée, le procédé comprend une étape 130 de calcul d'un deuxième indice de constance de la phase démodulée.

Pour une fréquence d'analyse prédéterminée, un tel indice de constance de phase démodulée peut par exemple renseigner sur la cohérence de l'évolution temporelle de la phase démodulée pour cette fréquence d'analyse.

Le calcul 120 de l'indice de constance de la phase démodulée peut comprendre le calcul d'une différence 130 de phase démodulée entre deux temps pour une fréquence donnée, par exemple modulo une certaine valeur, par exemple modulo $2\pi$.

Comme pour le premier indice de constance de phase démodulée, un tel deuxième indice de constance de phase démodulée peut permettre d'obtenir une précision fréquentielle sur les composantes du signal analysé bien meilleure que celle fournie par la transformée de Fourier.

Ce deuxième indice de constance de la phase démodulée présente en outre comme avantage d'être plus efficace face à une fréquence n'étant pas quasi-constante, c'est-à-dire que, dans le cas où une fréquence du signal varie dans le temps, cet indice ne rejette pas la fréquence d'analyse candidate mais garde un pouvoir discriminant. Ce deuxième indice de constance de la phase démodulée permet par exemple d'analyser des sons contenant un vibrato, un glissando, ou d'autres phénomènes impliquant une variation de fréquence, comme pour des composantes à fréquence lentement variable.

Le premier indice de constance de la phase démodulée permet de capturer les composantes aux fréquences stables dans le temps et de rejeter les composantes variant plus rapidement qu'un seuil réglable. Ainsi, il est par exemple particulièrement adapté à l'accordage d'instruments de musique, y compris en milieu bruyant, en présence d'impulsions ou de voix parlées. De façon complémentaire, le deuxième indice de constance de la phase démodulée, reposant sur la phase démodulée différentielle, permet de capturer les composantes fréquentielles variant dans le temps, et est adapté à un glissando, vibrato, etc. Dans les deux cas, la précision fréquentielle est réglable sur des plages de résolutions identiques.

Ainsi, il est possible calculer un indice de constance de la phase démodulée basé sur les premier et deuxième indices de constance de la phase démodulée, et/ou de mettre en oeuvre sélectivement le premier ou le deuxième indice en fonction d'un choix de l'utilisateur et/ou d'un algorithme décisionnel. Par exemple, le procédé peut mettre en oeuvre un indice de constance de la phase démodulé basé sur le premier indice de constance de la phase démodulée si l'utilisateur a indiqué qu'il cherchait à s'accorder, par exemple en actionnant un mode « accordeur » et que l'environnement est bruyant (par exemple bruit, impact, voix parlées, etc.), et mettre en oeuvre un indice de constance de la phase démodulé basé sur le deuxième indice de constance de la phase démodulée sinon.

Le procédé impliquant le calcul d'un tel deuxième indice diffère ainsi du ré-assignement spectral qui estime une fréquence F(f) pour chaque composante de Fourier à partir d'une différence ou dérivée temporelle de la phase non démodulée, et attribue l'énergie de chaque composante spectrale à la fréquence estimée F(f) plutôt que de la laisser localisée à la fréquence d'analyse f. En particulier, l'estimation mise en oeuvre dans le ré-assignement spectral n'exploite en aucun cas les variations selon la fréquence d'analyse f, de quantités, telles que la différence de phase démodulée, pour l'estimation de la fréquence recherchée.

La différence de phase démodulée $\tau$ est par exemple obtenue par une formule du type :

$$\tau\left(f,t,t'\right) = \Phi_{demod}(f,t) - \Phi_{demod}(f,t') \qquad [Z]$$

où $\tau$ représente la différence modulo Z pour la fréquence f et entre les temps t et t', Z étant par exemple un nombre réel, Z ayant par exemple pour valeur $2\pi$ si les phases sont exprimées en radian, par exemple de sorte que $\tau$ ait une valeur comprise entre -Z/2 et Z/2, par exemple entre $-\pi$ et $\pi$, et où $\Phi_{demod}$ représente la phase démodulée pour la fréquence $f$ et au temps $t$ ou $t'$.

Ainsi en fonction des valeurs de $\tau$, il est possible de déduire si, en moyenne sur la durée considérée, la phase de la composante analysée a augmenté moins vite ou plus vite que celle associée à la fréquence idéalement constante f, c'est-à-dire si la fréquence d'analyse f est une sur-estimation ou une sous-estimation.

Si $\tau$ est centrée sur 0 - c'est-à-dire que $\tau$ prend une valeur nulle quand les phases démodulées considérées pour le calcul de l'indice ont la même valeur - les lieux des changements de signe de $\tau$ selon la variable f, et plus précisément les passages par zéros, obtenus par exemple par interpolation, par exemple par interpolation affine, permettent d'identifier le passage entre surestimation ou sous-estimation, et donc de localiser les fréquences recherchées.

La différence 130 de phase démodulée est par exemple calculée entre deux trames $t_n$ et $t_{n-1}$, par exemple entre deux trames successives ou définissant un intervalle prédéterminé. La différence 130 est par exemple modulo une certaine valeur, par exemple modulo $2\pi$.

La différence de phase démodulée $\tau$ est ainsi par exemple obtenue par une formule du type :

$$\tau\left(f,t_n\right) = \Phi_{demod}(f,t_n) - \Phi_{demod}(f,t_{n-1}) \qquad [Z]$$

où $\tau$ représente la différence pour la fréquence f et entre les trames successives $t_n$ et $t_{n-1}$, modulo Z, Z ayant par exemple pour valeur $2\pi$, par exemple de sorte que $\tau$ ait une valeur comprise entre -Z/2 et Z/2, par exemple entre $-\pi$ et $\pi$, et où $\Phi_{demod}$ représente la phase démodulée pour la fréquence $f$ et au temps $t_n$ ou $t_{n-1}$.

Une valeur négative d'un tel $\tau$ traduit que, en moyenne sur la durée du pas d'avancement, la phase de la composante analysée a augmenté moins vite que celle associée à la fréquence idéalement constante f. Sur cette durée locale, la fréquence d'analyse f est alors une surestimation de la fréquence de la composante analysée. Réciproquement, une valeur positive de $\tau$ traduit que la fréquence d'analyse f est une sous-estimation de la fréquence de la composante analysée.

Le procédé peut ainsi comprendre une détection de la ou des composante(s) fréquentielle(s) estimée(s) exactement, par exemple pour laquelle (lesquelles) le deuxième indice de constance de phase démodulée est nul et/ou ou plus proche de 0 qu'un seuil donné.

Le procédé peut ainsi comprendre une détection de la ou des composante(s) fréquentielle(s) surestimée(s) pour laquelle (lesquelles) le deuxième indice de constance de phase démodulée est négatif ou inférieur à un seuil négatif donné.

Le procédé peut ainsi comprendre une détection de la ou des composante(s) fréquentielle(s) sous-estimée(s) pour laquelle (lesquelles) le deuxième indice de constance de phase démodulée est positif ou supérieur à un seuil positif donné.

L'indice peut être paramétré par une précision fréquentielle $\sigma$ réglable. La précision fréquentielle $\sigma$ réglable peut avoir pour valeur la fréquence de coupure définie précédemment.

De manière similaire au premier indice de constance de la phase démodulée, il résulte du fait que la phase est définie modulo une valeur prédéterminée, par exemple $2\pi$, et qu'un pas d'avancement est défini, que la plus grande

déviation détectable, notée $\sigma_{max}$, est par exemple de l'ordre de la moitié de l'inverse du pas d'avancement $p$, par exemple une déviation de l'ordre de 100Hz pour un pas d'avancement de 5 ms, c'est-à-dire :

$$\sigma_{max} = \frac{1}{2p}$$

Ainsi, pour tout $\sigma$ positif et $\sigma < \sigma_{max}$, le calcul de l'indice de constance de la phase démodulée peut comprendre le calcul d'un indice normalisé, noté $\gamma$, $\gamma$ pouvant par exemple être l'indice de constance de la phase démodulée, le calcul de $\gamma$ étant réalisé selon une formule du type :

$$\gamma = 1 - H\left( \tau \right)$$

où :

$$H\left( \tau \right) = SAT\left( \frac{\lvert \tau \rvert}{Z/2} \times (\sigma_{max}/\sigma) \right)$$

et où $\lvert . \rvert$ désigne la valeur absolue et la fonction de saturation $SAT(x)$ vaut $x$ si $x < 1$ et vaut $+1$ sinon.

L'indice $\gamma$ vaut alors 0 pour une composante fréquentielle qui, comparée à la fréquence d'analyse $f$, dévie négativement ou positivement d'au moins $\sigma$ et vaut $1-(\lvert\tau\rvert/\pi)(\sigma_{max}/\sigma)$ sinon. La cohérence idéale est alors obtenue pour $\gamma=1$, c'est à dire $\tau=0$.

Le procédé peut ainsi comprendre une détection de la ou des composante(s) fréquentielle(s) pour laquelle (lesquelles) l'indice $\gamma$ est maximale et/ou ou plus proche de son maximum qu'un seuil donné.

L'information portant sur la surestimation ou sous-estimation peut être conservée en prenant en compte le signe de $\tau$, par exemple pour un paramètre d'affichage, ou en adaptant la fonction H de sorte à ce qu'elle indique cette information.

Le procédé peut en outre comprendre une estimation d'au moins une largeur d'un intervalle fréquentiel entre deux changement de signe de $\tau$, par exemple des intervalles fréquentiels de part et d'autre d'un changement de signe de $\tau$, par exemple comparées à une référence, par exemple à $\sigma$, par exemple à $\sigma_{max}$, sur lesquelles le signe de $\tau$ est constant peut en outre fournir un critère de sinusoïdalité de la composante analysée. Le procédé peut en particulier comprendre une estimation de la moyenne géométrique des largeurs des intervalles fréquentiels de part et d'autre d'un changement de signe de $\tau$.

La qualité de la sinusoïdalité d'une composante analysée peut être estimée par une fonction croissante de la largeur des intervalles fréquentiels de part et d'autre du changement de signe de $\tau$, ou par exemple de la moyenne géométrique de ces largeurs.

Le procédé peut en particulier comprendre une étape de construction d'un vecteur des deuxièmes indices de constance de la phase démodulée associées à différentes fréquences d'analyse comprenant autant d'étapes de calcul de deuxièmes indices de constance de la phase démodulée.

Une telle étape de construction d'un vecteur des deuxièmes indices de constance de la phase démodulée comprend par exemple, pour chaque nouvelle trame, une étape de mémorisation du vecteur de phases démodulées calculé pour une trame précédente.

La construction d'un vecteur des deuxièmes indices de constance de la phase démodulée comprend par exemple une étape de construction d'un vecteur d'entiers, par exemple lorsque fournis par une formule du type :

$$\gamma = 1 - G\left( \tau_{int} \right)$$

où

$$G\left( \tau_{int} \right) = SAT\left( \left\lvert \frac{\tau_{int}}{2^{k_{bits}}/2} - 1 \right\rvert \times (\sigma_{max}/\sigma) \right)$$

$$\tau_{int}(f, t_n) = \Phi_{demod\,int}(f, t_n) - \Phi_{demod\,int}(f, t_{n-1}) + 2^{k_{bits}-1}$$

où $\tau_{int}$ et $\Phi_{demod\,int}$ sont les valeurs exprimées en entier encodé par un entier positif sur $k_{bits}$ bits de $\tau$ et $\Phi_{demod}$ respectivement.

Un calcul selon une telle formule présente un très faible coût de calcul pour la différence de phase démodulée, translate la valeur $\pi$ en 0 et assure le modulo $2\pi$. Plus précisément, elle translate la valeur -pi en 0, la valeur 0 sur 2^($k_{bits}$-1) et la valeur juste inférieure à pi sur l'entier maximal ($2^{k_{bits}}$)-1 : la valeur pi est représentée par l'entier $2^{k_{bits}}$ encodé sur $k_{bits}$ bits, c'est-à-dire, par l'entier 0.

Le procédé peut également comprendre une étape de construction d'une liste de fréquences à cohérence de phase exacte.

Pour chaque fréquence d'analyse, la construction d'une liste de fréquences à cohérence de phase exacte peut comprendre une étape de comparaison de la valeur du deuxième indice de constance de la phase démodulée, de sorte que si la valeur du deuxième indice de constance de la phase démodulé est caractéristique d'une phase démodulée cohérente temporellement, la fréquence étudiée est ajoutée à la liste, et sinon, une étape de calcul d'une fréquence exacte par interpolation peut être mise en oeuvre.

Selon un exemple, une telle étape comprend des étapes du type : Pour n allant de 1 à M-1, où M est la taille d'un vecteur des fréquences d'analyse dont 1 est le premier indice :

- si $\gamma(f_n)=1$, alors $f_n$ est ajoutée dans la liste de fréquences à cohérence de phase exacte ;
- sinon :

    o si :

    - $\tau_{float}(f_n).\tau_{float}(f_{n+1})<0$ et
    - $|\gamma(f_n)|>0$ et
    - $|\gamma(f_{n+1})|>0$;

    alors une fréquence $f_{exact}$ donnant un $\tau$ nul est calculée par une interpolation, par exemple une interpolation linéaire, par exemple une interpolation linéaire de fréquence, par exemple selon une formule du type :

$$f_{exact} = \frac{(\tau_{float}(f_{n+1}) \times f_n - \tau_{float}(f_n) \times f_{n+1})}{(\tau_{float}(f_{n+1}) - \tau_{float}(f_n))}$$

ou par exemple, une interpolation linéaire des log-fréquences, par exemple selon une formule du type :

$$\log(f_{exact}) = \frac{(\tau_{float}(f_{n+1}) \times \log(f_n) - \tau_{float}(f_n) \times \log(f_{n+1}))}{(\tau_{float}(f_{n+1}) - \tau_{float}(f_n))}$$

et $f_{exact}$ ainsi calculée par une interpolation est ajoutée dans la liste de fréquences à cohérence de phase exacte.

*Interpolation par un vecteur de fréquences*

Le procédé peut en outre comprendre une étape 112 de réception d'un vecteur de fréquences.

Les fréquences du vecteur de fréquence sont par exemple des fréquences accordées sur un diapason, c'est-à-dire que les fréquences sont accordées sur une note de référence. La fréquence de la note de référence est par exemple 440 Hz. La fréquence de la note référence peut par exemple être modifiée par l'utilisateur.

Les fréquences du vecteur de fréquence peuvent par exemple correspondre aux notes de musique de l'échelle tempérée (musique européenne classique).

Chaque note de musique peut par exemple être représentée par son code midi, par exemple selon la spécification internationale, par exemple telle que définie par « Complete MIDI 1.0 Detailed Specification ». La correspondance entre une fréquence $f$ et le code midi m d'une note est par exemple définie par la formule suivante :

$$f = f_{69} \times 2^{(m-69)/12}$$

où *69* est le code midi de la note la3 et $f_{69}$ vaut est une valeur de référence valant par exemple 440 Hz

Les fréquences du vecteur de fréquence peuvent alternativement correspondre aux notes de musique d'autres échelles musicales, issues par exemple de la musique orientale, ou d'échelles micro-tonales.

Le vecteur de fréquence est par exemple calculé une seule fois à l'initialisation du système 400. En cours de fonctionnement du système 400 le vecteur de fréquences peut n'être réinitialisé qu'à chaque nouveau réglage de la fréquence de référence par l'utilisateur.

Le procédé peut comprendre une étape 114 de calcul par interpolation des valeurs du signal acoustique transformé aux fréquences du vecteur de fréquences. Une telle étape 114 peut être réalisée préalablement à la démodulation 118 de phase.

Le procédé permet ainsi de construire un réhausseur de stationnarité fréquentielle des composantes spectrales de données acoustiques, en particulier d'un son, pour une grille de fréquences, par exemple une grille de fréquences accordées sur un diapason.

Un tel calcul 114 peut être réalisé de sorte que la démodulation 118 et le calcul 120 et/ou 130 d'indice de constance de phase sont réalisés pour chaque fréquence du vecteur de fréquences.

Ainsi, l'indice de constance de phase permet de marquer, pour chaque fréquence *f*, la pertinence de ladite fréquence, par exemple pour un indice proche de 1, ou son absence de pertinence, par exemple pour un indice proche de 0, en tant que composante sinusoïdale de fréquence *f*, et ceci, quelle que soit l'amplitude associée à la fréquence *f*.

L'interpolation 114 est par exemple une interpolation affine par morceaux. Les valeurs peuvent être des valeurs complexes obtenues par interpolation dans un plan complexe.

Une telle étape 114 peut être réalisée préalablement au calcul de l'indice de constance de phase démodulée.

Ceci est particulièrement avantageux, en particulier dans le cas où la phase démodulée est convertie en une exponentielle complexe de module constant. En effet, si l'interpolation devait être réalisée postérieurement à cette conversion, les valeurs interpolées pourraient se retrouver hors du cercle défini par le module constant, diminuant la robustesse de l'indice de constance de phase démodulée.

En réalisant cette interpolation sur des nombres complexes (en coordonnées cartésiennes ou de type a+ib) préalablement au calcul de l'indice de constance de phase, on peut établir une phase pertinente pour chaque fréquence d'une grille de fréquences accordée sur un diapason, la grille étant choisie pour être celle sur laquelle on souhaite accorder de façon précise.

*Calcul de coordonnées polaires*

Le procédé peut comprendre une étape 116 de calcul des coordonnées polaires du signal acoustique transformé.

L'étape 116 de calcul des coordonnées polaires peut être réalisée préalablement à l'étape 118 de démodulation de phase.

L'étape 116 de calcul des coordonnées polaires peut être réalisée suite à l'étape 114 de calcul par interpolation.

Les coordonnées polaires comprennent par exemple le module et la phase modulo $2\pi$ des valeurs complexes du signal acoustique transformé associées à chaque fréquence du vecteur de fréquences.

*Réalisation d'une image*

Le procédé décrit peut ainsi par exemple permettre de fournir au moins un vecteur de données, par exemple une pluralité de vecteurs de données, par exemple des vecteurs de données correspondant au vecteur de fréquences et/ou au module des valeurs complexes du signal acoustique transformé associées à chaque fréquence du vecteur de fréquences et/ou à la phase démodulée, et/ou à l'indice de constance de phase démodulée et/ou aux indices de constance de phase démodulée.

Au moins un des vecteurs de données, par exemple plusieurs ou tous, peut par exemple correspondre à un tableau de valeurs d'analyse de trames de signal acoustique ayant une durée déterminée, par exemple de l'ordre de 50 ms.

Un ou plusieurs des vecteurs de données peut par exemple être rafraîchi à une cadence déterminée, par exemple par le pas d'avancement p du procédé, qui est par exemple de l'ordre de 5 ms.

Le procédé peut comprendre en outre une étape 122 de réalisation d'au moins une image adaptée pour être affichée sur un terminal, l'image étant réalisée au moins à partir des données acoustiques et de l'indice de constance de phase démodulée, ou des indices de constance de phase démodulée.

Il est ainsi possible de combiner l'analyse fréquentielle des données acoustiques et un affichage, par exemple un affichage en temps réel. Il est ainsi possible de visualiser l'information spectrale obtenue en sortie des étapes précédemment décrites.

Le procédé peut ainsi comprendre une étape 122 de réalisation de plusieurs telles images. Chaque image peut par exemple correspondre à des données calculée pour un temps $t$, par exemple un avancement $t_n$.

Le système 400 comprend par exemple le terminal. Le terminal comprend par exemple un afficheur. L'afficheur peut par exemple fonctionner avec une fréquence de rafraîchissement déterminée propre à l'afficheur, la fréquence de rafraîchissement étant par exemple comprise entre 50 Hz et 122 Hz.

*Réception de données*

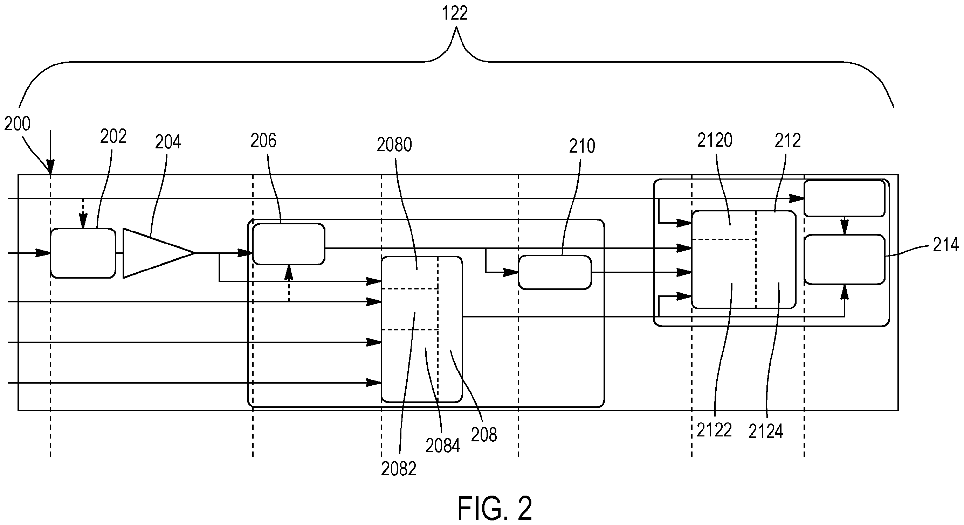

En référence à la figure 2, l'étape 122 de réalisation de l'image comprend par exemple une étape 200 de réception de données. Les données comprennent par exemple le vecteur de fréquences reçu, et/ou le module des valeurs complexes du signal acoustique transformé associées à chaque fréquence du vecteur de fréquences, et/ou la phase démodulée, et/ou l'indice de constance de phase démodulée ou plusieurs indices de constance de phase démodulée.

Les données sont par exemple reçues par paquets, par exemple par paquets ordonnés. Chaque paquet correspond par exemple à une trame analysée au cours des étapes décrites ci-avant. Chaque paquet peut comprendre les quatre vecteurs de sortie de l'analyseur.

Ces données peuvent alors être traitées pour construire l'image à afficher. Les données de plusieurs paquet peuvent être simultanément prises en compte pour construire une même image, par exemple pour un afficheur à mémoire, par exemple un tel afficheur de type sonagramme. Les données d'un unique paquet peuvent être prises en compte pour construire une image, par exemple pour un afficheur instantané de type spirale tel que décrit plus loin.

*Normalisation de l'amplitude*

L'étape 122 de réalisation de l'image comprend par exemple une étape 202 de conversion du module des valeurs complexes du signal acoustique transformé associées à chaque fréquence du vecteur de fréquences sur une échelle et/ou une étape 204 de normalisation du module des valeurs complexes du signal acoustique transformé associées à chaque fréquence du vecteur de fréquences.

La conversion 202 est par exemple une conversion du module sur une échelle adaptée à la perception pour chaque fréquence du vecteur de fréquences. L'échelle est par exemple une échelle en sonie comprenant par exemple des courbes isosoniques normales de la norme ISO 226:2003. Alternativement, l'échelle est par exemple une échelle en décibels.

Le système 400 peut permettre de sélectionner une échelle parmi l'échelle en sonie et l'échelle en décibels.

La normalisation 204 comprend par exemple une normalisation entre une valeur minimale, par exemple 0, et une valeur maximale, par exemple 1. La normalisation comprend par exemple une saturation à la valeur minimale de normalisation au-dessous d'un seuil bas, par exemple 0 phones ou 20dB-spl, et/ou une saturation à la valeur maximale de normalisation au-dessus d'un seuil haut, par exemple 100 phones ou 122dB-spl.

*Elément visuel*

En référence à la figure 3, l'image 300 peut comprendre un élément visuel 302 correspondant à la fréquence du domaine fréquentiel. L'élément visuel 302 peut correspondre à la fréquence du domaine fréquentiel pour un temps t.

La représentation de l'élément visuel 302 peut être fonction de l'amplitude de la fréquence et de l'indice de constance de phase démodulée et/ou des indices de constance de phase démodulée.

Un tel élément visuel 302 permet une visualisation des données traitées, en particulier de l'indice de constance de phase démodulée et/ou des indices de constance de phase démodulée.

Une telle visualisation peut ainsi être reliée à un percept auditif. Il est ainsi possible de stimuler des mises en relations sonores/visuelles, et donc de permettre des applications du procédé à la pédagogie, par exemple la pédagogie musicale en vue d'affiner la justesse de l'oreille de façon interactive.

Un tel élément visuel 302 permet l'obtention d'une représentation aisément intelligible pour la personne visualisant l'image, qui peut par exemple être appréhendée par des enfants et/ou sans mode d'emploi.

En outre, l'utilisation d'une résolution fréquentielle plus précise qu'une analyse spectrale standard pour des notes établies stables permet une utilisation efficace du procédé en fonction accordeur.

Il est ainsi possible de réaliser au même moment un stimulus auditif et un stimulus visuel. La mise en oeuvre d'un tel procédé peut ainsi être en cohérence avec l'échelle perceptive selon laquelle on ne voit que ce qu'on entend. Il est ainsi possible d'obtenir un procédé aisé à appréhender pour l'utilisateur et permettant une compréhension instinctive des données calculées précédemment, en particulier par l'utilisation de l'indice de constance de phase démodulée et/ou des indices de constance de phase démodulée.

Il est ainsi possible d'obtenir une visualisation spectrale du son, qui reste discriminante si elle organisée par hauteurs, par exemple par notes, alors qu'une analyse de Fourier standard serait trop grossière.

Il est ainsi possible d'accéder à des résolutions suffisamment fines pour permettre d'accorder un instrument de musique.

L'image peut comprendre une grille 304. L'élément visuel 302 est par exemple disposé devant la grille 304.

La représentation de l'élément visuel 302 peut comprendre différentes caractéristiques visuelles. Les caractéristiques peuvent comprendre une épaisseur et/ou une couleur et/ou une transparence.

L'élément visuel 302 comprend par exemple une forme 302, par exemple un trait, par exemple un trait 302 d'une spirale 306 comprenant une pluralité de traits 302, chaque trait 302 étant associé à une fréquence du vecteur de fréquences.

Dans le cas d'une spirale 306, la grille 304 est par exemple une grille 304 circulaire ou en forme de spirale 306.

L'étape 122 de réalisation de l'image 300 comprend par exemple une étape 206 de calcul de l'épaisseur de la forme 302, par exemple du trait. L'épaisseur est par exemple normalisée entre une valeur minimale ou nulle, par exemple 0, et une valeur maximale, par exemple 1.

L'épaisseur peut ainsi permettre de faire ressortir les composantes sinusoïdales présentes, avec une résolution fréquentielle suffisamment fine pour être au moins proche de celle de la justesse détectable par l'oreille.

L'épaisseur de la forme 302, par exemple du trait est par exemple une fonction croissante du module normalisé et/ou de l'indice de constance de la phase démodulée et/ou des indices de constance de la phase démodulée.

Pour chaque fréquence $f$ du vecteur de fréquence, l'épaisseur $T$ peut par exemple être donnée par une formule du type :

$$T = M_{norm} \times (\Phi_{const})^{Stress}$$

où M est le module normalisé, $\Phi_{const}$ l'indice de constance de phase démodulée, et *Stress* un paramètre déterminé compris par exemple entre 0 et 2, par exemple entre 0 exclus et 2, par exemple réglable entre 0 et 2, par exemple de valeur 1. Lorsque *Stress* vaut 0, l'épaisseur correspond exactement au module normalisé. Lorsque le paramètre *Stress* est strictement positif, l'indice de constance de phase démodulée vient réhausser les composantes spectrales à fréquence stationnaires dans la plage tolérée par le filtre passe-bas. Par exemple, pour un paramètre *Stress* de valeur 2, l'épaisseur des composantes non stationnaires est significativement réduite.

L'étape 122 de réalisation de l'image 300 comprend par exemple une étape 208 de calcul de couleur de forme 302, par exemple du trait, par exemple pour chaque fréquence du vecteur de fréquence. L'étape de calcul de couleur peut comprendre le calcul 2080 d'une brillance et/ou le calcul 2084 d'une teinte et/ou le calcul 2082 d'une saturation.

En particulier, la brillance est par exemple calculée fonction du module normalisé. La forme 302, par exemple le trait, est par exemple d'autant plus visible que l'amplitude pour l'échelle associée, par exemple en décibel ou en sonie, est grande. La brillance est par exemple calculée sans prendre en compte l'effet de la stationnarité de la fréquence, en particulier indépendamment de l'indice de constance de phase démodulée. Ainsi, quel que soit le type de composante (sinusoïdal, bruit, impact, etc), un évènement deux fois plus fort (échelle de la sonie) sera deux fois plus brillant (échelle perceptive de la vision). A sonie donnée, la brillance est la même quel que soit le type de composante. Par ailleurs, une composante sinusoïdale sera plus marquée géométriquement (« épaisseur du trait plus ample ») qu'une composante d'un autre type.

En particulier, la teinte est par exemple calculée en fonction de la phase démodulée. En outre, la teinte est par exemple calculée en respectant une condition de circularité, de sorte qu'une phase nulle et une phase de 360° sont représentées par la même teinte.

En particulier, la saturation est par exemple calculée en fonction de l'indice de constance de phase démodulée. Ainsi, une composante stationnaire peut être très colorée et une composante peu stationnaire peut être d'autant plus décolorée et/ou blanchie que l'indice de constance de phase démodulée est faible.

Les zones colorées peuvent ainsi isoler les composantes sinusoïdales des autres types de composantes, correspondant par exemple à des bruits ou des impacts.

La constance de la couleur peut ainsi par exemple correspondre à une phase démodulée constante. La constance d'une couleur associée à une fréquence cible d'accordage peut ainsi permettre d'identifier la perfection d'un accord sur cette fréquence, par exemple au-delà du seuil de détectabilité de la justesse de l'oreille humaine, et de garantir ainsi, par exemple, que deux instruments accordés sur cette base ne produiront pas de battement s'ils jouent à l'unisson. Par exemple, une variation de couleur cyclique sur cinq secondes peut indiquer que des battements cycliques de cinq secondes sont susceptibles se produire. Alternativement, la teinte peut être exclusivement contrôlée par le module normalisé. Une telle coloration ne représente plus d'information de phase mais surcharge l'information de représentation de l'amplitude. Une telle surcharge permet de simplifier la lecture sur l'image 300 de situations acoustiques, par exemple sonores, complexes et d'alléger l'effort d'analyse visuelle. La qualité de la stationnarité qui raffine la précision fréquentielle visualisée reste encore prise en charge par l'épaisseur, par exemple l'épaisseur et/ou par la saturation de la couleur de la forme 302, par exemple du trait de la spirale 306.

En particulier, la teinte est par exemple calculée en fonction de l'indice de constance de phase démodulée. Ceci permet une surcharge d'information qui facilite la prise en compte de l'information par l'oeil d'un utilisateur.

L'étape 122 de réalisation de l'image 300 comprend par exemple une étape 210 de calcul de transparence de la forme 302, par exemple du trait, par exemple pour chaque fréquence du vecteur de fréquence.

La transparence peut être calculée de sorte que si la forme 302, par exemple le trait, devient très fine, il n'en résulte pas un écrasement de l'abaque en spirale 306.

En effet, il est ainsi possible d'éviter que des évènements quasi-inaudibles, tels qu'un faible bruit, construisent un trait par exemple peu épais et par exemple peu brillant, c'est-à-dire presque noir, qui viendrait masquer le trait de l'abaque, et ainsi d'éviter l'effet de scintillement du trait de l'abaque qui en résulte et a un effet visuellement perturbant.

Il est ainsi possible que la grille 304 reste visible lors de l'affichage de l'image 300, sans effet de scintillement pour les éléments visuels 302 correspondant à des fréquences à faible pertinence tels que des fréquences correspondant à des modules faibles ou très instationnaires.

La transparence est par exemple une fonction croissante de l'épaisseur de la forme 302, par exemple du trait, par exemple linéairement croissante, par exemple entre une valeur minimale, par exemple 0, et une valeur maximale, par exemple 1. La transparence peut être saturée à la valeur minimale en-dessous d'une certaine valeur d'épaisseur, et/ou saturée à la valeur maximale au-dessus d'une certaine valeur d'épaisseur.

*Représentations graphiques*

L'étape 122 de réalisation d'image comprend par exemple la construction 212 et/ou 214 de représentations graphiques à afficher.

En particulier, l'étape 122 de réalisation d'image peut comprendre par exemple le tracé 2120 de la grille 304, par exemple de la grille 304 de la spirale 306. L'étape 122 de réalisation d'image peut comprendre le tracé 2122 de la spirale colorée formée des éléments visuels et l'affichage 2124 de la spirale 306 et de la grille 304.

Par exemple, pour des données acoustiques comprenant une plage de notes à afficher, par exemple encodées via des codes midi compris entre une valeur minimale et une valeur maximale, on construit une grille 304 dont le rayon est par exemple calculé en coordonnées polaires par une formule du type :

$$\rho(\theta) = 1 + (\theta - \theta_{min})$$

où $\theta$ est l'angle en coordonnées polaires, $\rho$ le rayon en coordonnées polaires, et $\theta_{min}$ la valeur minimale d'angle, par exemple en prenant la valeur minimale en code MIDI, et dont l'angle est par exemple calculé en degré par une formule du type :

$$\theta = 360 \frac{(Midi_{code} - 69)}{12} + \theta_{ref}$$

$$\Theta(midi\_code) = 360.(midi\_code-69)/12 + A4ReferenceAngle$$

où midicode représente le code midi de la note considérée, et où $\theta_{ref}$ représente l'angle de référence.

Ainsi, la construction d'une telle grille 304 revient par exemple à construire une spirale 306 en effectuant un tour par octave de sorte que toutes les notes en relation d'octave sont alignées et sont associées au même angle sur la spirale.

Dans le cas d'un affichage sur un écran tactile, l'angle peut par exemple être modifié en posant un ou plusieurs doigts sur la représentation de la spirale 306 sur l'écran, et en effectuant un mouvement de rotation avec le ou les doigts. La grille 304 peut par exemple représenter la position des notes tempérées par des lignes appuyées et/ou des subdivisions par des lignes moins appuyées.

L'étape 122 de réalisation d'image peut comprendre par exemple une étape 2124 successive de superposition sur la grille 304 de la spirale 306. La superposition 2124 est par exemple réalisée avec le niveau de transparence local réglé par la transparence calculée au préalable.

Une telle superposition 2124 est par exemple réalisée avec une interpolation adaptée aux nombres de pixels disponibles, par construction vectorielle de l'image 300 colorée.

Une telle représentation permet de fournir une représentation limitant la perte des informations obtenues aux étapes précédentes. Une telle représentation peut ainsi être compatible avec un usage professionnel en production, par exemple dans le cadre d'activités d'ingénieur du son, de mastering, ou de restauration d'enregistrements anciens.

Ainsi, plutôt que sur un axe, le spectre peut être représenté sur un squelette en spirale qui assure l'alignement des fréquences si un alignement est souhaitable. Par exemple, dans le cas de données sonores, les notes peuvent être alignées en relation d'octave. Il est ainsi possible de réaliser une topologie cohérente avec la notion de note musicale sur une échelle tempérée.

Dans le cadre d'une utilisation en tant qu'accordeur un tel procédé, il est possible de ne recourir à aucune estimation de hauteur de note, estimation qui est souvent mal définie pour les sons réels.

Le procédé permet de se passer d'estimation en permettant à l'utilisateur, par sa perception visuelle de l'image 300 et en particulier de l'élément visuel 302, d'être lui-même l'accordeur.

Si un son est bien harmonique, accorder se résumera à aligner correctement une composante fondamentale sur une grille 304 de la note visée, et éventuellement les harmoniques en relation d'octaves.

Si l'harmonicité n'est pas idéale, la notion de hauteur ne coïncide plus avec la fréquence fondamentale et devient mal posée de sorte que les accordeurs standards donnent des estimations dépendantes des méthodes choisies par les constructeurs.

En effet, dans un tel cas, le signal n'est pas un signal idéalement périodique. Dans un tel cas, les composantes fréquentielles du signal acoustique, par exemple du son, ne suivent par exemple pas exactement une progression harmonique avec une $k^{ème}$ harmonique ayant une fréquence $f_k$ multiple d'une fréquence fondamentale $f_1$, par exemple $f_k = k*f_1$.

Par exemple des cordes (spécialement pour les notes graves de piano), les barres (vibraphone, marimba, etc) ou des cloches ne suivent pas de progression harmonique.

Le procédé et le système 400 décrits peuvent permettre à l'utilisateur de visualiser le résultat spectral pour chaque composante, et d'apprécier lui-même le compromis à ajuster.

Un tel procédé et un tel système 400 peuvent donc s'avérer particulièrement utiles dans le cas de relations de quasi-octaves, où les composantes ne peuvent plus être alignées exactement avec le centre de la spirale.

Le procédé décrit peut donc permettre de comprendre la source de la difficulté de l'accordage dans un tel cas, source qui est complètement masquée pour un accordeur standard, et d'y remédier par les retours auditifs et visuels à partir desquels le choix par l'utilisateur d'un compromis sera guidé par sa propre expérience psycho-acoustique plutôt qu'une estimation au sens d'un modèle idéalisant.

En complément, le procédé peut comprendre en réponse à la sélection d'une note par un utilisateur, une étape de représentation agrandie et redressée de la portion de la spirale 306 pour cette fréquence, par exemple pour cette note, et par exemple également des zones voisines, par exemple des zones voisines sur une octave. Une telle fonctionnalité est particulièrement adaptée à la mise en oeuvre d'un système 400 accordeur.

Dans le cas d'un affichage sur un écran tactile, en complément, le procédé peut comprendre, en réponse à la sélection d'une note par un utilisateur, une étape de génération d'un son qui correspond à cette note accordée sur le diapason réglé, par exemple sinusoïde pure de la fréquence de la note pointée.

Alternativement ou en complément, la construction de représentations graphiques à afficher comprend par exemple le tracé 214 d'une image colorée de type « sonagramme », et par exemple son affichage.

Un tel tracé 214, utilisé en complément de la représentation en spirale 306, permet une préservation de la mémoire des images déjà affichées, en représentant un historique de ces images 306.

L'abscisse du sonagramme correspond par exemple au temps $t_n$ de chaque trame. L'ordonnée du sonagramme correspond par exemple aux fréquences du vecteur de fréquence, par exemple aux notes des fréquences analysées. La couleur de chaque point est par exemple calculée comme indiqué précédemment.

De même, un tel affichage peut être réalisé avec une interpolation adaptée aux nombres de pixels disponibles, par construction vectorielle de l'image colorée.

Un tel procédé peut être mis en oeuvre dans le cadre de différents modes de fonctionnement possibles. Par exemple, lorsque les données sont des données sonores, des modes de fonctionnement possibles sont par exemple chants d'enfants, chorale, jeu d'instruments, accordeur, post-production et analyse du signal musical et sonore.

En mode accordeur, l'accord est par exemple effectué par le musicien en modifiant son instrument pour centrer sur la grille 304 accordée le percept visuel associé à la composante spectrale détectée. Si besoin pour des configurations particulières, le procédé peut permettre d'affiner encore plus la qualité d'accordage, par exemple au-delà des capacités de l'oreille sur un son monodique, de sorte à assurer l'absence de « battements » avec d'autres instruments mais sans nécessiter la présence d'un second instrument. Pour cela, l'instrumentiste doit par exemple assurer que la couleur, si elle est associée à la phase démodulée, ou bien ne varie pas (accordage idéal), ou bien dérive très lentement (la période d'un « tour de couleur » correspondant par exemple à la période du battement avec un autre instrument parfaitement accordé avec une phase démodulée idéalement constante.

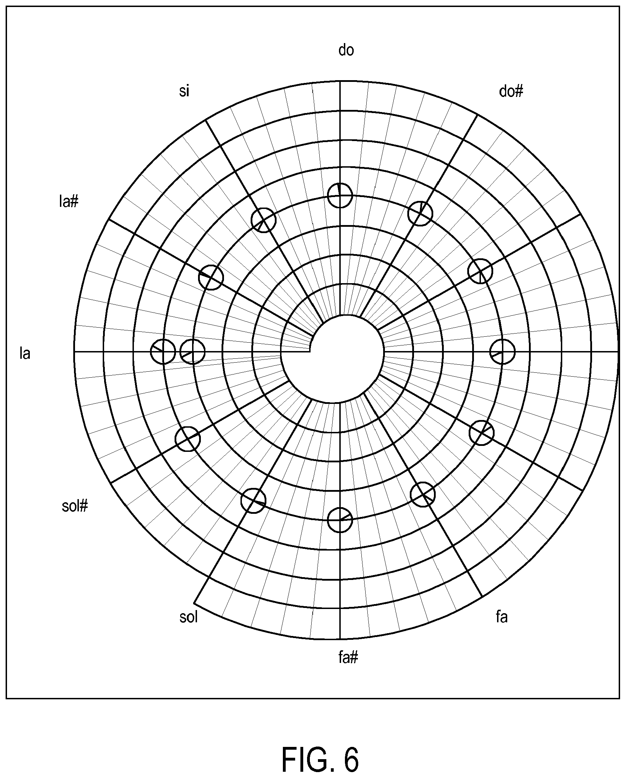

En référence à la figure 6, les représentations graphiques peuvent être surchargées par un ou plusieurs éléments visuels supplémentaires, chacun disposé au niveau d'une fréquence d'analyse cible, par exemple 110 Hz, par exemple à des fréquences de notes tempérées, par exemple sur plusieurs octaves, et accordées sur un diapason.

La surcharge est par exemple une surimpression qui peut être activée ou désactivée.

Ces éléments visuels supplémentaires représentent par exemple graphiquement la valeur de la phase démodulée, par exemple au moyen d'un sous-élément dont la position, par exemple l'orientation, dépend de la valeur de la phase démodulée.

Le sous-élément forme par exemple un trait, par exemple un trait inséré dans un élément d'encadrement de l'élément visuel supplémentaire tel qu'un cercle, le trait formant par exemple un rayon du cercle tournant en fonction de la valeur de la phase démodulée.

La teinte et/ou la brillance et/ou la saturation d'au moins une partie de l'élément visuel supplémentaire, par exemple de l'élément d'encadrement, peut également être basée sur la valeur de la phase modulée pour la fréquence considérée.

La vitesse de rotation fournit ainsi une information à l'utilisateur sur la constance de la phase démodulée.

Les éléments visuels supplémentaires peuvent ainsi former un élément de réglage fin lors d'un accordage, lorsque la précision fournie par la représentation graphique décrite ci-dessus ne suffit plus pour l'utilisateur. En effet, il est ainsi possible de raffiner l'accordage bien au-delà des capacités de détection de justesse par une oreille experte, avec pour intérêt perceptif de supprimer les battements lors de la superposition de plusieurs sons, dus par exemple à la présence de plusieurs cordes à accorder sur une même note sur un piano.

A titre d'exemple illustratif, un élément visuel supplémentaire sur le "la 440Hz" permet d'observer un changement visuel, par exemple au niveau de la couleur et/ou en concordance avec l'angle du rayon représenté, de façon cyclique avec un cycle de T secondes, si la déviation fréquentielle est de 1/T. Ainsi, pour un son incluant une composante fréquentielle de 440,1 Hz=440+1/T avec T=10 secondes, on verra sur le symbole du "la 440 Hz" la couleur et le rayon effectuer un cycle en 10 secondes.

*Traitement des harmoniques*

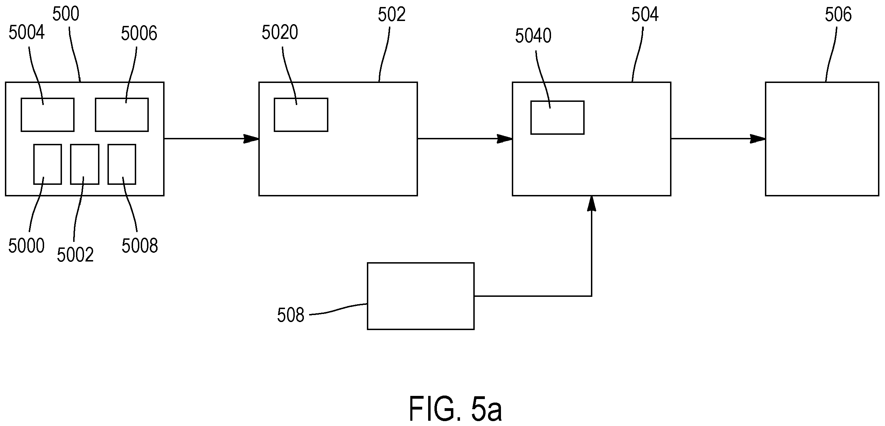

En référence à la figure 5a, alternativement ou en complément des étapes décrites ci-dessus, le procédé peut comprendre un traitement d'harmoniques, un tel traitement pouvant être suivi par la construction d'une représentation graphique à partir d'un tel traitement.

*Etape de répartition*

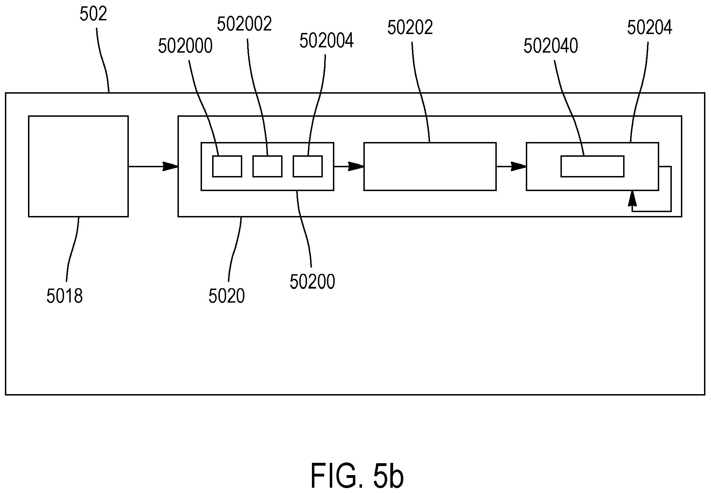

Ainsi, en référence à la figure 5b, le procédé peut comprendre une étape 502 de répartition d'une partie d'une énergie d'une fréquence $f$ traitée vers des énergies de fréquences sous-harmoniques de la fréquence traitée, par exemple selon des proportions déterminées.

Une telle étape 502 de répartition peut être réalisée pour plusieurs fréquences f d'une plage fréquentielle d'analyse donnée, par exemple fixée par les bornes du vecteur de fréquence. Une telle étape de répartition peut être réalisée pour chaque trame donnée.

Une telle étape 502 de répartition peut être réalisée itérativement, par exemple itérativement par octave, par exemple itérativement par octave décroissante.

L'étape 502 de répartition peut par exemple être mise en oeuvre par le système 400 de traitement de données acoustiques.

La répartition peut être déterminée au prorata d'une fonction d'énergie de sous-harmoniques ramenée à l'énergie de la fréquence f testée. Une telle fonction est par exemple une fonction monotone, par exemple une fonction croissante.

Alternativement ou en complément, la répartition peut être déterminée en fonction des indices de constance de phase de sous-harmoniques et de la fréquence $f$ testée, par exemple avec une activation qui est fonction des indices de constance de phase de sous-harmoniques et de la fréquence $f$ testée, la fonction étant par exemple une fonction monotone des indices de constance de phase, par exemple une fonction croissante.

Il est ainsi possible de sélectionner les harmoniques susceptibles de participer à un timbre perçu, par rapport à d'autres signaux tels que des bruits.

L'étape de répartition 502 peut ainsi comprendre, par exemple pour chaque trame, une étape 5020 d'obtention de contributions harmoniques, les contributions harmoniques permettant par exemple de quantifier une marque de présence de contribution harmonique associée à une hauteur de structure quasi-périodique telle qu'une note.

Une telle répartition permet de quantifier la présence de notes potentielles parmi les harmoniques, les notes potentielles étant celles qui ont reçu le plus d'énergie à l'issue de l'étape de répartition.

*Représentation graphique de contributions harmoniques*

Les contributions harmoniques peuvent être mises en oeuvre dans la construction d'une représentation graphique.

Les contributions harmoniques sont par exemple obtenues sous la forme d'amplitudes de contribution harmonique. De telles amplitudes sont ainsi aisées à intégrer dans une représentation graphique.

Le procédé peut ainsi comprendre une étape 504 subséquente de construction d'une image dont un élément visuel au moins est construit en fonction des contributions harmoniques, par exemple des amplitudes de contribution harmonique. Le procédé peut également comprendre une étape 506 subséquente d'affichage d'une telle image, par exemple par le système 400, par exemple par un afficheur.

En particulier, le procédé peut ainsi permettre de mettre en oeuvre une extension en trois dimensions des images décrites ci-avant réalisées par exemple en deux dimensions. L'extension en trois dimensions peut par exemple être mise en oeuvre de sorte qu'à harmonique h fixée, au moins une partie des caractéristiques visuelles déjà mises en oeuvre sont réutilisées, par exemple la totalité de ces caractéristiques visuelles, les caractéristiques visuelles réutilisées comprenant par exemple attributs de couleur et d'épaisseur de forme, par exemple de trait, telles que définies précédemment.

L'extension en trois dimensions peut par exemple représenter plusieurs images en deux dimensions de données associées à différentes valeurs d'harmoniques. L'extension en trois dimensions peut ainsi par exemple prendre en compte une troisième coordonnée spatiale z. La troisième coordonnée spatiale est par exemple utilisée pour représenter les images en deux dimensions des données associées à différentes valeurs d'harmoniques. Les images en deux dimensions sont par exemple aux altitudes z=$\log_2$(h), en particulier pour des valeurs telles que 0, 1, $\log_2$(3), 2, $\log_2$(5), etc..

Le procédé peut ainsi comprendre la construction d'un vecteur qui quantifie la présence de notes à des fréquences déterminées. Un tel vecteur peut être utilisé en tant qu'amplitude dans l'afficheur en deux dimensions décrit précédemment, de sorte que l'image indique la présence de notes.

L'étape 504 de construction d'image peut comprendre l'application 5040 d'une interpolation, par exemple entre les altitudes décrites, par exemple pour au moins une caractéristique visuelle telle que l'épaisseur de la forme, par exemple l'épaisseur du trait, la couleur et/ou la transparence. L'interpolation 5040 est par exemple constante ou affine par morceaux.

Il est ainsi possible d'obtenir visuellement des structures en "chaînes de montagnes" représentant le nombre et la présence des harmoniques. En particulier, la hauteur totale et la largeur en fonction de l'altitude peuvent être fonction respectivement du nombre et de la présence des harmoniques. De telles "chaînes de montagnes" peuvent ainsi par exemple évoluer avec le timbre.

Il est ainsi possible, sans établir d'estimations de notes, de fournir par une image en trois dimensions une aide à la localisation visuelle de notes avec une caractérisation du timbre, tel qu'un réhaussement visuel pour l'indication de la présence de notes.

Une telle image en trois dimensions peut ainsi constituer un indicateur élaboré, plus adapté à la mise en relation avec la perception de la musique.

De plus, il est ainsi possible de répartir d'une façon équilibrée l'énergie de chaque fréquence sur un ensemble de contributions harmoniques, par exemple vers des fréquences ciblées et déterminées par leur activation énergétique et leur qualité de stationnarité.

De même, l'inharmonicité n'est pas traitée au sens d'un gabarit ou d'un modèle paramétrique de déviation. L'inharmonicité est toutefois prise en charge par le procédé dans la mesure où la fréquence quasi-harmonique traitée divisée par un index harmonique h est localisé dans un lobe principal d'une fréquence d'une note testée par le procédé.

Un exemple de mode de réalisation détaillé d'un tel traitement des harmoniques est détaillé ci-après.

*Tableau de phases démodulées*

Le procédé peut comprendre, en amont de l'étape 502 de répartition, une étape 500 de réception de données, par exemple comprenant la réception 5000 de la phase démodulée, par exemple d'une pluralité de phases démodulées, par exemple d'un vecteur de données correspondant à la phase démodulée pour une ou plusieurs trames.

Le procédé peut comprendre une étape de réception ou de calcul 5002 d'un tableau de phases démodulées comprenant la phase démodulée d'au moins une fréquence du vecteur de fréquences et d'au moins une harmonique de ladite fréquence du vecteur de fréquence.

La h$^{\text{ème}}$ harmonique $f_{k,h}$, h étant par exemple un entier naturel, de la k$^{\text{ème}}$ fréquence $f_k$, k étant par exemple un entier naturel, du vecteur de fréquences est par exemple déterminée par une formule du type :

$$f_{k,h} = f_k \times h$$

En particulier, le procédé peut comprendre une telle étape 5002, de sorte à ce que le tableau de phases démodulées comprennent de telles phases démodulées pour toutes les fréquences du vecteur de fréquence et une pluralité d'harmoniques pour chaque fréquence du vecteur de fréquence.

Une telle étape 500 peut par exemple comprendre le calcul de la phase démodulée pour la ou les harmoniques de fréquence du vecteur de fréquence par interpolation. L'interpolation est par exemple une interpolation « au plus proche voisin » ou affine par morceau. L'encodage peut être un encodage entier, par exemple sur 32 bits, pour garantir la précision et le modulo décrits précédemment.

Les fréquences $f_{k,h}$ disposées au-delà des valeurs extrémales du vecteur de fréquences peuvent ne pas être prises en compte.

*Tableau d'indices de phase démodulée*

De même, le procédé peut comprendre une étape de réception 5004 de l'indice de phase démodulée, par exemple d'une pluralité d'indices de phase démodulée, par exemple d'un vecteur de données correspondant à l'indice de phase démodulée pour une ou plusieurs trames.

Le procédé peut comprendre une étape de réception ou de calcul 5006 d'un tableau d'indices de phases démodulées comprenant la phase démodulée d'au moins une fréquence du vecteur de fréquences et d'au moins une harmonique de ladite fréquence du vecteur de fréquence.

En particulier, le procédé peut comprendre une telle étape 5006, de sorte à ce que le tableau d'indices de phase démodulée comprenne de tels indices pour toutes les fréquences du vecteur de fréquence et une pluralité d'harmoniques pour chaque fréquence du vecteur de fréquence.

Une telle étape 500 peut par exemple comprendre le calcul de l'indice de phase démodulée pour la ou les harmoniques de fréquence du vecteur de fréquence par interpolation. L'interpolation est par exemple une interpolation « au plus proche voisin » ou affine par morceau. L'encodage peut être un encodage entier, par exemple sur 32 bits, pour garantir la précision et le modulo décrits précédemment.

Les fréquences $f_{k,h}$ disposées au-delà des valeurs extrémales du vecteur de fréquences peuvent ne pas être prises en compte.

*Tableau de contributions harmoniques*

La contribution harmonique est par exemple une amplitude de contribution harmonique.

De même, le procédé peut comprendre une étape de réception 5018 de contributions harmoniques, par exemple d'une pluralité de contributions harmoniques, par exemple d'un vecteur de données correspondant à des contributions harmoniques pour une ou plusieurs trames. Le procédé peut comprendre une étape de réception ou de calcul 5020 d'un tableau de contributions harmoniques comprenant la contribution harmonique associée à au moins une fréquence du vecteur de fréquences et d'au moins une harmonique de ladite fréquence du vecteur de fréquence.

Il est ainsi possible d'identifier les fréquences d'origine de l'énergie reçue par une harmonique.

Une telle étape permet ainsi de construire une représentation visuelle caractéristique du timbre.

En particulier, le procédé peut comprendre une telle étape 5020, de sorte à ce que le tableau de contributions harmoniques comprenne de telles amplitudes pour toutes les fréquences du vecteur de fréquence et une pluralité d'harmoniques pour chaque fréquence du vecteur de fréquence.

L'étape de calcul 5020 d'un tableau d'amplitudes est par exemple une étape de calcul par itération.

L'étape de calcul 5020 d'un tableau de contributions harmoniques comprend par exemple une étape d'initialisation 50200.

L'étape d'initialisation 50200 comprend par exemple une étape 502000 de réception d'un vecteur d'énergies des fréquences du vecteur de fréquence.

Les énergies sont par exemples des énergies normalisées. Ainsi, l'étape d'initialisation 50200 peut par exemple comprendre une étape 502002 de normalisation des énergies. La normalisation 501002 consiste par exemple à rendre la somme des énergies égale à une valeur donnée, par exemple à une valeur d'unité.

La normalisation 502002 est par exemple obtenue par une formule du type :

$$E_{norm}(f_k) = \frac{E(f_k)}{E_{tot}}$$

où $E_{norm}(f_k)$ est l'énergie normalisée pour la $k^{ème}$ fréquence du vecteur de fréquence, où $E(f_k)$ est l'énergie pour la la $k^{ème}$ fréquence du vecteur de fréquence, et où $E_{tot}$ est l'énergie totale.

L'énergie d'une fréquence, est par exemple l'énergie stockée dans une bande fréquentielle associée à cette fréquence, par exemple une bande fréquentielle stockée sur cette fréquence.

Les bandes fréquentielles sont par exemple des bandes connexes, par exemple formant un recouvrement d'une plage de fréquences donnée.

Les fréquences du vecteur de fréquences suivent par exemple une progression en suite, par exemple en suite géométrique. Chaque fréquence peut être associée à une bande de fréquence, de sorte que les bandes de fréquences correspondant à des fréquences qui se suivent sont connexes. Chaque bande de fréquences est par exemple centrée sur la fréquence correspondante, par exemple centrée au sens d'une moyenne géométrique.

La largeur $L_f$ d'une bande associée à une fréquence f est par exemple fournie par une formule du type :

$$L_f = K \times f$$

avec K un coefficient indépendant de la fréquence, dont la valeur est par exemple fournie par une formule du type :

$$K = 2 \times \sinh(\ln(2) \times R_{MIDI}/24)$$

où $R_{MIDI}$ est par exemple une valeur de pas fractionnaire entre deux valeurs de code MIDI correspondant à deux fréquences consécutives du vecteur de fréquence.

L'énergie $E(f_k)$ dans la bande de largeur $L_{fk}$ associée à la fréquence donnée $f_k$ peut ainsi par exemple être fournie par une formule du type :

$$E(f_k) = K \times f_k \times A_k^2$$

Où $A_k$ est l'amplitude du signal pour la fréquence $f_k$.

L'énergie totale $E_{tot}$ peut alors être définie comme la somme des énergies pour toutes les fréquences $f_k$.

L'étape d'initialisation 50200 comprend par exemple en outre une étape 502004 de construction d'un tableau initial des contributions harmoniques. L'étape 502004 correspond par exemple à la construction d'un tableau initial des amplitudes de contribution harmonique $A_{Harmo,k}(h)$, par exemple de sorte que $A_{Harmo,k}(1) = A_k$, et $A_{Harmo,k}(h)=0$ pour des harmoniques d'index h compris entre 2 et $H_{max}$, où $H_{max}$ est par exemple un vecteur des indices harmoniques maximaux associés aux fréquences du vecteur de fréquence.

Le vecteur des indices harmoniques maximaux est par exemple défini par :

$$H_{max}(k) = \mathrm{Floor}\left(\frac{F_{max}}{f_k}\right)$$

où Floor est la partie entière, par exemple arrondie par défaut, $F_{max}$ la borne supérieure de la plage de fréquences traitées.

La plage de fréquences traitées est par exemple du type $[F_{min}, F_{max}]$ avec $F_{min}$ la valeur minimale parmi les fréquences du vecteur de fréquences et $F_{max}$ la valeur maximale parmi les fréquences du vecteur de fréquences. La plage de fréquences traitées comprend par exemple une pluralité d'octaves pleines, le nombre d'octaves pleines $N_{octaves}$ étant par exemple déterminé par une formule du type :

$$N_{octaves} = \mathrm{Floor}(\log_2(F_{max}/F_{min}))$$

où Floor définit par exemple la partie entière, par exemple la partie entière par défaut. Le procédé peut alors comprendre la réception ou la construction d'une séquence décroissante de fréquences de plage $F_{plage}$, par exemple pour n entier naturel allant de 1 à $N_{octaves}$, par exemple par une formule du type

$$F_{plages}(n) = 2^{1-n} \times F_{max}$$

par exemple de sorte que les octaves traitées par l'étape de ré-assignation 50204 des énergies de bandes fréquentielles décrite ci-après correspondent aux plages fréquentielles Plage(n), par exemple ouvertes à gauche et fermées à droite, du type :

$$Plage(n) = \left] F_{plages}(n+1) ; F_{plages}(n) \right]$$

L'étape de calcul 5020 par itération comprend par exemple une étape 50102 de calcul de coefficients de transfert pour chaque fréquence du vecteur de fréquence appartenant la plage de fréquences traitées, par exemple de calcul d'un vecteur de tels coefficients.

L'étape 50202 de calcul de coefficients de transfert est par exemple réalisée au prorata d'une fonction croissante de l'énergie $E(f_k/sh)$, où sh est un indice sous-harmonique, ladite énergie étant ramenée à l'énergie $E(f_k)$ de la fréquence $f_k$ testée. sh est ainsi un indice sous harmonique correspondant à une fréquence réceptrice d'énergie pour l'étape de ré-assignation, l'énergie étant pompée depuis la fréquence f testée, par exemple localisée par construction hors de l'octave analysée. Une telle étape est par exemple réalisée pour des indices sous-harmoniques sh=2,3,..,$SH_{max}(k)$, où $SH_{max}(k)$ est le $k^{ème}$ coefficient d'un vecteur des indices sous-harmoniques maximaux associés aux fréquences du vecteur de fréquences, ledit coefficient étant par exemple défini par une formule du type :

$$SH_{max}(\mathrm{k}) = \mathrm{Floor}(f_k/F_{\min})$$

L'étape 50202 de calcul de coefficients de transfert est par exemple réalisée avec une activation qui est fonction croissante des indices de constance de phase de l'émetteur d'énergie, c'est-à-dire de la fréquence testée, et du récepteur d'énergie c'est-à-dire des indices sous-harmoniques correspondants.

Une telle étape 50202 de calcul de coefficients de transfert est par exemple réalisée de sorte à pomper l'énergie $E_{norm}(f_k)$ et n'en laisser qu'une proportion Coeff(1).

En outre, une telle étape 50202 de calcul de coefficients de transfert est par exemple réalisée de sorte à répartir le reste de l'énergie $E_{norm}(f_k)$ vers les sous-harmoniques d'indices sh, compris entre 2 et $SH_{max}(k)$, par exemple en transférant les proportions Coeff(sh) vers les fréquences d'indice KSH(k,sh). Par construction de Plage(n), toutes les fréqences réceptrices d'énergie sont inférieures à Plage(n).

L'entier KSH(k,sh) est par exemple défini de sorte que $f_{KSH(k,sh)}$ est la valeur du vecteur de fréquences la plus proche de la fréquence sous-harmonique $f_k/sh$.

L'étape 500 comprend par exemple une étape 5008 de réception ou de construction d'un tableau des entiers KSH(k,sh). Puisque la valeur maximale de sh dépend de k, un tel tableau n'est pas nécessairement rectangulaire et seule la partie complétée est utile. De ce fait, un encodage par liste peut être choisi pour un stockage en mémoire plus compact.

Le vecteur de coefficients de transfert positifs, et par exemple de somme 1, est donné par une formule du type :

$$Coeff(sh) = \mathrm{C(sh)}/C_{tot}$$

où $C_{tot}$ est la somme des composantes C(sh) et où, C(sh) est par exemple défini comme suit :

$$C(1) = 1$$

et pour sh compris entre 2 et $SH_{max}(k)$ :

$$C(sh) = (\Phi_{const}(k) \times \Phi_{const}(k, sh))^{a/2} \times \left(E_{norm}(KSH(k, sh)) \Big/ E_{norm}(k)\right)^{b/2 \times (\Phi_{const}(k) \times \Phi_{const}(k, sh))^{c/2}}$$ où $\Phi_{const}(k)$ est l'indice

de constance de phase démodulée, $\Phi_{const}(k,sh)$ est par exemple défini comme $\Phi_{const}(f_{KSH(k,sh)})$, a, b c sont des coefficients, par exemple compris entre 0 et 100, par exemple tels que a=0,1, b=10 et c=0,1.

Les coefficients a, b et c sont par exemple modifiables. Le choix a=c=0 rend par exemple l'attribution insensible à la constance de phase.

*Ré-assignation des énergies et amplitudes*

Le procédé peut par exemple comprendre une étape 50204 de réassignation des énergies et amplitudes.

Le procédé peut ainsi comprendre une étape 502040 de mise à jour du vecteur d'énergie, par exemple du vecteur d'énergie normalisée et du tableau d'amplitudes de contributions harmoniques. Une telle étape 502040 permet d'effectuer le transfert des amplitudes en garantissant la préservation de l'énergie.

L'étape 502040 de mise à jour comprend par exemple une étape de transfert des amplitudes de contributions harmoniques vers les sous-harmoniques ("récepteur" d'énergie).

Par exemple, l'étape de transfert peut comprendre, pour chaque indice sous-harmonique sh allant de 2 à $SH_{max}$ (k), l'application de formules du type:

$$ksh = KSH(k,sh)$$

où ksh est l'indice de la fréquence sous-harmonique traitée,

$$E_{norm}(ksh) = E_{norm}(ksh) + Coeff(sh) \times E_{norm}(k)$$

$$h=sh$$

où h est l'indice harmonique de base traité pour la fréquence sous-harmonique traitée.

L'étape de transfert peut en outre comprendre, pour $h_{bis}$ allant de 1 à $min(H_{max}(k), Floor(F_{max}/(F(ksh) \times h)))$, l'application d'une formule du type :

$$A_{Harmo,ksh}(h \times h_{bis}) = (A_{Harmo,ksh}(h \times h_{bis})^2 + Coeff(sh) \times A_{Harmo,k}(h_{bis})^2)^{0,5}$$

où $h_{bis}$ correspond aux indices harmoniques de la fréquence $f_k$ déjà traités et que l'on doit aussi tous transférer, et où la puissance 0.5 dans la formule provient du fait que l'on traite des amplitudes et non des énergies, une telle puissance étant est nécessaire pour garantir la préservation d'énergie totale.]

L'étape 502040 de mise à jour peut comprendre en outre une étape dite de pompage, par exemple de pompage sur l' "émetteur" d'énergie.

L'étape de pompage comprend par exemple l'application de formules du type :

$$E_{norm}(k) = Coeff(1) \times E_{norm}(k)$$

et pour $h_{bis}$ allant de 1 à $H_{max}(k)$ :

$$A_{Harmo,k}(hbis) = Coeff(1)^{0,5} \times A_{Harmo,k}(hbis)$$

Le procédé comprend par exemple l'itération de l'étape 502040 de mise à jour pour chaque indice k de sorte que $f_k$ appartient à Plage(n).

*Construction de vecteur d'amplitude*

Le procédé peut en outre comprendre une étape 508 de construction du vecteur d'amplitudes caractérisant la présence de notes sans information de timbre.

Le vecteur AmpNote associé aux fréquences f est par exemple donné par:

$$AmpNote(k) = (E_{norm}(k) \times E_{tot}/L_{fk})^{0,5}$$

**Système**

En référence à la figure 4, il est décrit un système 400 de traitement de données acoustiques.

Le système 400 est par exemple un système électronique de traitement et de stockage de données, par exemple de type serveur ou poste de travail informatique.

Le système 400 est adapté pour mettre en oeuvre un procédé tel que décrit précédemment.

Le système 400 comprend un module 402 de réception de données acoustiques correspondant à un signal acoustique transformé dans le domaine fréquentiel à partir d'un signal acoustique dans le domaine temporel enregistré par au moins un capteur acoustique,

Le système 400 comprend un module 404 de démodulation de la phase du signal acoustique transformé pour au moins une fréquence du domaine fréquentiel, et

Le système 400 comprend un module 406 de calcul d'un indice de constance de la phase démodulée.

Le système peut comprendre un module (non représenté) de réhaussement visuel de présence de notes. Le module de réhaussement visuel peut comprendre un indicateur de timbre.

On comprendra que selon un mode de réalisation, le système comprend un moyen de traitement de données de type processeur adapté pour mettre en oeuvre les modules 402, 404, 406 précités qui peuvent donc être des modules logiciels. Alternativement, on comprendra que les modules 402, 404 et 406 peuvent être des modules physiques.

Le système 400 peut en outre comprendre des moyens de stockage de données, tels qu'un disque dur, pour le stockage des données acoustiques et/ou des résultats.

Le système 400 comprend en outre une interface, par exemple un afficheur, par exemple un écran permettant d'afficher des graphiques et/ou des images résultant du procédé décrit ci-dessus, de sorte à restituer les données associées à destination d'un utilisateur.

### Produit programme d'ordinateur

Selon un autre aspect, l'invention concerne un produit programme d'ordinateur comprenant des instructions de code pour l'exécution d'un procédé de traitement tel que décrit précédemment.

### Moyens de stockage

Selon encore un autre aspect, l'invention concerne des moyens de stockage lisibles par un équipement informatique sur lesquels un produit programme d'ordinateur comprend des instructions de code pour l'exécution d'un procédé de traitement tel que décrit précédemment.

### Revendications

1. Procédé de traitement de données acoustiques mis en oeuvre par un système de traitement de données acoustiques, comprenant des étapes de:

   - réception (110) de données acoustiques correspondant à un signal acoustique transformé dans le domaine fréquentiel à partir d'un signal acoustique dans le domaine temporel enregistré par au moins un capteur acoustique,
   - pour au moins une fréquence du domaine fréquentiel, démodulation (118) de la phase du signal acoustique transformé, et
   - calcul (120) d'un premier indice de constance de la phase démodulée comprenant l'application (1202) d'un filtre passe-bas, le filtre passe-bas étant adapté pour réaliser une atténuation en fonction de la vitesse de rotation de la phase démodulée, et/ou
   - calcul (120) d'un deuxième indice de constance de la phase démodulée comprenant le calcul d'une différence (130) de phase démodulée entre deux temps pour la fréquence du domaine fréquentiel.
   - calcul d'un indice de constance de la phase démodulée basé sur les premier et deuxième indices

   et / ou
   la mise en oeuvre sélectivement du premier ou du deuxième indice.

2. Procédé selon la revendication 1, comprenant en outre des étapes de :

   - réception (112) d'un vecteur de fréquences,
   - calcul (114) par interpolation des valeurs du signal acoustique transformé aux fréquences du vecteur de fréquences,

   de sorte que la démodulation (118) est réalisée pour chaque fréquence du vecteur de fréquences.

3. Procédé selon l'une des revendications 1 ou 2, dans lequel la phase démodulée est obtenue par une formule du type :

$$\Phi_{demod}\,(f,t) = \Phi_{spectr}\,(f,t) - 2\pi ft \qquad \mathrm{mod}\ 2\pi$$

où $\Phi_{demod}$ représente la phase démodulée pour la fréquence et au temps t, et où $\Phi_{spectr}$ représente la phase du signal transformé pour la pour la fréquence et au temps t.

4. Procédé selon la revendication 1, dans lequel le calcul d'un indice de constance de la phase démodulée comprend, préalablement à l'application (1202) du filtre passe-bas la conversion (1200) de la phase démodulée en une exponentielle complexe de module constant, le filtre passe-bas étant appliqué à l'exponentielle complexe, l'indice de constance de la phase démodulée résultant du module d'une sortie complexe du filtre passe-bas.

5. Procédé selon la revendication 1, dans lequel l'indice de constance de la phase démodulée est paramétré par une précision fréquentielle réglable.

6. Procédé selon l'une quelconque des revendications 1 à 5, comprenant en outre des étapes de :

   - réception d'une valeur de variation de fréquence à détecter,
   - réception (104) de données acoustiques correspondant au signal acoustique dans le domaine temporel enregistré par l'au moins un capteur acoustique,
   - transformation (108) du signal acoustique dans le domaine temporel en le signal dans le domaine fréquentiel par transformée de Fourier discrète pondérée par une fenêtre d'analyse,

   la transformée étant réalisée avec un pas d'avancement déterminé de sorte que l'inverse du double du pas d'avancement est supérieur à :

   - la largeur du lobe principal de la fenêtre d'analyse dans le domaine de Fourier, et à
   - la valeur de variation de fréquence à détecter.

7. Procédé selon l'une quelconque des revendications 1 à 6, dans lequel le signal acoustique enregistré est un signal sonore et dans lequel le signal acoustique dans le domaine temporel enregistré est échantillonné.

8. Procédé selon l'une quelconque des revendications 1 à 7, comprenant en outre une étape (122) de construction d'une image (300) représentative de la constance de phase démodulée issue des données acoustiques, l'image étant adaptée pour être affichée sur un terminal, l'image (300) étant construite à partir des données acoustiques et de l'indice de constance de phase démodulée.

9. Procédé selon la revendication 8, dans lequel la construction (122) de l'image comprend un élément visuel (302) correspondant à la fréquence du domaine fréquentiel, la représentation de l'élément visuel (302) étant fonction de l'amplitude de la fréquence et de l'indice de constance de phase démodulée.

10. Procédé selon l'une quelconque des revendications 1 à 9, dans lequel l'étape de démodulation comprend une étape (180) d'encodage de la phase, en particulier par une valeur rationnelle, en particulier avec un nombre de bits.

11. Procédé selon l'une quelconque des revendications 1 à 10, dans lequel l'étape de démodulation comprend une étape d'application d'une formule de démodulation pour cet encodage, du type :

$$\Phi_{demod}\,(f,t_n) = \Phi_{spectr}\,(f,t_n) + \Delta_{demod}$$

où $\Phi_{demod}$ représente la phase démodulée pour la fréquence f et au temps $t_n$ obtenu par incrémentation d'un pas d'avancement, le temps $t_n$ pour la $n^{ème}$ incrémentation étant obtenu par une formule du type :

$$t_n = n \times t_{av}$$

où $t_n$ est le pas d'avancement,
où $\Phi_{spectr}$ représente la phase du signal transformé pour la fréquence f et au temps t,
où le vecteur $\Delta_{demod}$ est rafraichi à chaque temps $t_n$ par une formule du type :

$$\Delta_{\text{demod}} = \Delta_{\text{demod}} + \delta$$

où $\delta$ est l'encodage entier positif de -$2\pi ft_{av}$ ou vaut -$2\pi ft_{av}$.

12. Système de traitement de données acoustiques, adapté pour mettre en oeuvre un procédé selon l'une quelconque des revendications 1 à 11, **caractérisé en ce qu'**il comprend :

- un module (402) de réception de données acoustiques correspondant à un signal acoustique transformé dans le domaine fréquentiel à partir d'un signal acoustique dans le domaine temporel enregistré par au moins un capteur acoustique
- un module (404) de démodulation de la phase du signal acoustique transformé pour au moins une fréquence du domaine fréquentiel, et
- un module (406) de calcul d'un indice de constance de la phase démodulée, le module appliquant un filtre passe-bas, le filtre passe-bas étant adapté pour réaliser une atténuation en fonction de la vitesse de rotation de la phase démodulée et/ou calculant une différence (130) de phase démodulée entre deux temps pour la fréquence du domaine fréquentiel.

**Patentansprüche**

1. Verfahren zur Verarbeitung von akustischen Daten, durchgeführt von einem System zum Verarbeiten akustischer Daten, aufweisend die Schritte:

- Empfangen (110) von akustischen Daten, die einem akustischen Signal entsprechen, das ausgehend von einem von mindestens einem akustischen Sensor aufgezeichneten Signal im Zeitbereich in den Frequenzbereich transformiert wurde,
- für mindestens eine Frequenz im Frequenzbereich, Demodulation (118) der Phase des transformierten akustischen Signals und
- Berechnung (120) eines ersten Stabilitätsindex der demodulierten Phase, aufweisend das Anwenden (1202) eines Tiefpassfilters, wobei das Tiefpassfilter eingerichtet ist, eine Dämpfung in Abhängigkeit von der Rotationsgeschwindigkeit der demodulierten Phase durchzuführen und/oder
- Berechnung (120) eines zweiten Stabilitätsindex der demodulierten Phase aufweisend das Berechnen einer demodulierten Phasendifferenz (130) zwischen zwei Zeiten für die Frequenz des Frequenzbereichs
- Berechnung eines Stabilitätsindex der demodulierten Phase basierend auf dem ersten und zweiten Index

und/oder
selektiver Einsatz des ersten oder des zweiten Stabilitätsindex.

2. Verfahren nach Anspruch 1, ferner aufweisend die Schritte:

- Empfang (112) eines Frequenzvektors,
- Berechnung (114) durch Interpolation der Werte des transformierten akustischen Signals bei den Frequenzen des Frequenzvektors,

in der Art, dass die Demodulation (118) für jede Frequenz des Frequenzvektors durchgeführt wird.

3. Verfahren nach einem der Ansprüche 1 oder 2, wobei die demodulierte Phase durch eine Formel des Typs erhalten wird:

$$\Phi_{\text{demod}}(f,t) = \Phi_{\text{spectr}}(f,t) - 2\pi ft \quad \text{mod } 2\pi$$

wobei $\Phi_{\text{demod}}$ die demodulierte Phase für die Frequenz und Zeit zur t darstellt und wobei $\Phi_{\text{spectr}}$ die Phase des transformierten Signals für die Frequenz und zur Zeit t darstellt.

4. Verfahren nach Anspruch 1, wobei die Berechnung eines Stabilitätsindex der demodulierten Phase vor dem Anwenden (1202) des Tiefpassfilters das Umwandeln (1200) der demodulierten Phase in einen komplexen Exponentialterm mit konstantem Betrag aufweist, wobei das Tiefpassfilter auf den komplexen Exponentialterm angewendet wird und der Stabilitätsindex der demodulierten Phase sich aus dem Betrag einer komplexen Ausgabe des Tiefpassfilters ergibt.

5. Verfahren nach Anspruch 1, wobei der Stabilitätsindex der demodulierten Phase durch eine einstellbare Frequenzgenauigkeit eingestellt wird.

6. Verfahren nach einem der Ansprüche 1 bis 5, das ferner die Schritte aufweist:

- Empfangen eines zu erfassenden Frequenzänderungswerts,
- Empfangen (104) von akustischen Daten, die dem von dem mindestens einem akustischen Sensor aufgezeichneten akustischen Signal im Zeitbereich entsprechen,
- Transformation (108) des akustischen Signals im Zeitbereich in das Signal im Frequenzbereich durch diskrete Fourier-Transformation, gewichtet mittels eines Analysefensters,

wobei die Transformation mit einem Vorrückschritt durchgeführt wird, der derart bestimmt ist, dass die Umkehrung des Doppelten des Vorrückschritts größer ist als:

- die Breite der Hauptkeule des Analysefensters im Fourier-Bereich und
- der zu erfassende Frequenzänderungswert.

7. Verfahren nach einem der Ansprüche 1 bis 6, wobei das aufgezeichnete akustische Signal ein Tonsignal ist und wobei das aufgezeichnete akustische Signal im Zeitbereich abgetastet wird.

8. Verfahren nach einem der Ansprüche 1 bis 7, ferner aufweisend einen Schritt (122) zum Konstruieren eines Bildes (300), das für die aus den akustischen Daten abgeleitete demodulierte Phasenstabilität repräsentativ ist, wobei das Bild eingerichtet ist, auf einem Endgerät angezeigt zu werden und wobei das Bild (300) aus den akustischen Daten und dem Stabilitätsindex der demodulierten Phase aufgebaut ist.

9. Verfahren nach Anspruch 8, wobei die Konstruktion des Bildes (122) ein visuelles Element (302) aufweist, das der Frequenz des Frequenzbereichs entspricht, wobei die Darstellung des visuellen Elements (302) eine Funktion der Amplitude der Frequenz und des demodulierten Stabilitätsindex der demodulierten Phase ist.

10. Verfahren gemäß einem der Ansprüche 1 bis 9, in dem der Schritt der Demodulation einen Schritt (180) des Kodierens der Phase, insbesondere mittels eines rationalen Werts, insbesondere mittels einer Anzahl von Bits, aufweist.

11. Verfahren gemäß einem der Ansprüche 1 bis 10, in dem der Schritt der Demodulation einen Schritt der Anwendung einer Demodulationsformel für dieses Kodieren aufweist vom Typ:

$$\Phi_{demod}(f,t_n)= \Phi_{spectr}(f,t_n) + \Delta_{demod}$$

wobei $\Phi_{demod}$ die demodulierte Phase für die Frequenz f und zur Zeit $t_n$, erhalten durch die Inkrementierung eines Vorrückschritts, repräsentiert, wobei die Zeit $t_n$ für die n-te Inkrementierung erhalten wird durch eine Formel des Typs:

$$t_n = n \times t_{av}$$

wobei $t_n$ der Vorrückschritt ist,
wobei $\Phi_{spectr}$ die Phase des transformierten Signals für die Frequenz f und zur Zeit t ist,
wobei der Vektor zu jeder Zeit $t_n$ aufgefrischt wird durch eine Formel vom Typ:

$$\Delta_{demod} = \Delta_{demod} + \delta$$

wobei $\delta$ die ganzzahlig positive Kodierung von $-2\pi f_{av}$ ist oder den Wert $-2\pi f_{av}$ hat.

**12.** System zum Verarbeiten akustischer Daten, eingerichtet zum Implementieren eines Verfahrens nach einem der Ansprüche 1 bis 11, **dadurch gekennzeichnet, dass** es aufweist:

- ein Modul (402) zum Empfangen von akustischen Daten, die einem akustischen Signal entsprechen, das ausgehend von einem akustischen Signal im Zeitbereich, das von mindestens einem akustischen Sensor aufgezeichnet wurde, in den Frequenzbereich transformiert wurde,
- ein Modul (404) zum Demodulieren der Phase des transformierten akustischen Signals für mindestens eine Frequenz der Frequenzdomäne, und
- ein Modul (406) zum Berechnen eines Stabilitätsindex der demodulierten Phase, wobei das Modul ein Tiefpassfilter anwendet, wobei das Tiefpassfilter eingerichtet ist, eine Dämpfung in Abhängigkeit von der Rotationsgeschwindigkeit der demodulierten Phase durchzuführen und/oder eine demodulierte Phasendifferenz (130) zwischen zwei Zeiten für die Frequenz des Frequenzbereichs berechnet.

**Claims**

**1.** Method for processing acoustic data carried out by a system for processing acoustic data, comprising steps of:

- reception (110) of acoustic data corresponding to an acoustic signal transformed into the frequency domain starting from an acoustic signal in the time domain recorded by at least one acoustic sensor,
- for at least one frequency of the frequency domain, demodulation (118) of the phase of the transformed acoustic signal, and
- calculation (120) of a first consistency coefficient of the demodulated phase, comprising the application (1202) of a low-pass filter, the low-pass filter being adapted to carry out an attenuation as a function of the speed of rotation of the demodulated phase, and/or
- calculation (120) of a second consistency coefficient of the demodulated phase, comprising the calculation of a demodulated phase difference (130) between two times for the frequency of the frequency domain,
- calculation of a consistency coefficient of the demodulated phase on the basis of the first and second coefficients and/or the selective implementation of the first or the second coefficient.

**2.** Method according to claim 1, further comprising steps of:

- reception (112) of a frequency vector,
- calculation (114) by interpolation of the values of the transformed acoustic signal at the frequencies of the frequency vector,

such that the demodulation (118) is carried out for each frequency of the frequency vector.

**3.** Method according to either claim 1 or claim 2, wherein the demodulated phase is obtained by a formula of the type:

$$\Phi_{demod}(f,t) = \Phi_{spectr}(f,t) - 2\pi ft \qquad \mathrm{mod}\ 2\pi$$

where $\Phi_{demod}$ represents the demodulated phase for the frequency and at time t, and
where $\Phi_{spectr}$ represents the phase of the transformed signal for the frequency and at time t.

**4.** Method according to claim 1, wherein the calculation of a consistency coefficient of the demodulated phase comprises, prior to the application (1202) of the low-pass filter, the conversion (1200) of the demodulated phase into a complex exponential of constant modulus, the low-pass filter being applied to the complex exponential, the consistency coefficient of the demodulated phase resulting from the modulus of a complex output of the low-pass filter.

**5.** Method according to claim 1, wherein the consistency coefficient of the demodulated phase is parameterised by an adjustable frequency accuracy.

**6.** Method according to any one of claims 1 to 5, further comprising steps of:

- reception of a frequency variation value to be detected,
- reception (104) of acoustic data corresponding to the acoustic signal in the time domain recorded by the at least one acoustic sensor,
- transformation (108) of the acoustic signal in the time domain into the signal in the frequency domain by discrete Fourier transform weighted by an analysis window,

the transform being carried out with an advancement step determined so that the inverse of twice the advancement step is greater than:

- the width of the main lobe of the analysis window in the Fourier domain, and
- the frequency variation value to be detected.

7. Method according to any one of claims 1 to 6, wherein the recorded acoustic signal is a sound signal, and wherein the recorded acoustic signal in the time domain is sampled.

8. Method according to any one of claims 1 to 7, further comprising a step (122) of construction of an image (300) representing the demodulated phase consistency obtained from the acoustic data, the image being adapted to be displayed on a terminal, the image (300) being constructed from the acoustic data and the demodulated phase consistency coefficient.

9. Method according to claim 8, wherein the construction (122) of the image comprises a visual element (302) corresponding to the frequency of the frequency domain, the representation of the visual element (122) being dependent on the amplitude of the frequency and the demodulated phase consistency coefficient.

10. Method according to any one of claims 1 to 9, wherein the demodulation step comprises a step (180) of encoding of the phase, in particular by a rational value, in particular with a number of bits.

11. Method according to any one of claims 1 to 10, wherein the demodulation step comprises a step of application of a demodulation formula for that encoding, of the type:

$$\Phi_{demod}\left(f, t_n\right) = \Phi_{spectr}\left(f, t_n\right) + \Delta_{demod}$$

where $\Phi_{demod}$ represents the demodulated phase for the frequency f and at time $t_n$ obtained by incrementation by an advancement step, the time $t_n$ for the $n^{th}$ incrementation being obtained by a formula of the type:

$$t_n = n \times t_{av}$$

where $t_n$ is the advancement step,
where $\Phi_{spectr}$ represents the phase of the transformed signal for the frequency f and at time t,
where the vector $\Delta_{demod}$ is refreshed at each time $t_n$ by a formula of the type:

$$\Delta_{demod} = \Delta_{demod} + \delta$$

where $\delta$ is the positive integer encoding of $-2\pi f t_{av}$ or is $-2\pi f t_{av}$.

12. System for processing acoustic data, adapted to carry out a method according to any one of claims 1 to 11, **characterised in that** it comprises:

- a module (402) for receiving acoustic data corresponding to an acoustic signal transformed into the frequency domain starting from an acoustic signal in the time domain recorded by at least one acoustic sensor,
- a module (404) for demodulating the phase of the transformed acoustic signal for at least one frequency of the frequency domain, and
- a module (406) for calculating a consistency coefficient of the demodulated phase, the module applying a low-pass filter, the low-pass filter being adapted to carry out an attenuation as a function of the speed of rotation of the demodulated phase and/or calculating a demodulated phase difference (130) between two times for the frequency of the frequency domain.

FIG. 1

FIG. 2

EP 3 155 609 B1

300

C

B                    C#

A#                        D

306

A                              D#          304

302

G#                        E

FIG. 3    G          F

F#

400

402

404

406

FIG. 4

FIG. 5a

EP 3 155 609 B1

FIG. 5b

FIG. 6

## RÉFÉRENCES CITÉES DANS LA DESCRIPTION

**Documents brevets cités dans la description**

- FR 56159

**Littérature non-brevet citée dans la description**

- Fourier-based methods for the spectral analysis of musical sounds. *MARCHAND Sylvain, 21st European Signal Processing Conférence (EUSIPCO 2013),* 09 Septembre 2013
- **T. HÉLIE.** Amélioration de l'extraction de partiels dans les signaux sonores. *Rapport de Stage Ingénieur,* 1996
- **L. COHEN.** Time-Frequency Analysis. Prentice-Hall, 1995
- **A. V. OPPENHEIM ; R. W. SCHAFER.** Digital Signal Processing. Prentice-Hall, 2011